# EUROPEAN PATENT APPLICATION

(11) **EP 4 250 331 A1**
(43) Date of publication of application: **27.09.2023**
(21) Application number: 22163592.3
(22) Date of filing: 22.03.2022
(51) Int. Cl.: H01J 37/317, H01J 37/153

(54) **CHARGED PARTICLE APPARATUS AND METHOD**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

A charged particle device projects charged-particle beams along beampaths towards a sample location. The device comprises: a charged-particle lens assembly for manipulating the beams and a controller . The lens assembly comprises plates each having an aperture array for passage of beampaths. The plates are at different plate locations along the beampaths. The controller controls the charged-particle device such that charged particles of the beams have different energy values at the different plate locations along the beampaths. The lens assembly comprises a corrector comprising an individual correctors configured to perform aberration correction at respective apertures independently of each other. The corrector is associated with the plate at the plate location at which the energy value is smallest, the strength of an electric field adjacent to the plate is greatest and/or a ratio of the energy value to strength of an electric field adjacent to the plate is smallest.

## Description

### FIELD

The embodiments provided herein generally relate to charged particle-optical apparatuses and methods for controlling a charged particle-optical apparatus.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The generated signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection tool may obtain an image representing characteristics of the material structure of the surface of the sample. The intensity of the electron beams comprising the signal electrons may vary based on the properties of the internal and external structures of the sample, and thereby may indicate whether the sample has defects.

The beam of electrons may be focused and otherwise manipulated by electron-optical lenses. Imperfections of the lenses can result in imperfections of the electron beam. For example, if a lens is manufactured such that it as a diameter or ellipticity different from its target diameter or ellipticity, then the primary beam of electrons may have a size and/or shape that is different from its intended size and/or shape for example when incident on a sample.

### SUMMARY

It is an object of the present disclosure to provide embodiments that support beams of charged particles having more tightly controlled properties (e.g. size and/or shape) and/or embodiments that increase the manufacturing tolerances for charged particle-optical lenses for a given accuracy of properties of the beams.

According to a first aspect of the invention, there is provided a charged particle-optical device for projecting a plurality of charged particle beams along respective beam paths towards a sample location, the device comprising:
a charged particle-optical lens assembly configured to manipulate the beams, the lens assembly comprising a plurality of plates each having an array of apertures for passage of beam paths, the plates located at different plate locations along the beam paths; and
a controller configured to control the charged particle-optical device such that in use charged particles of the beams can have different energy values at the different plate locations along the beam paths;
wherein the lens assembly comprises a corrector comprising a plurality of individual correctors configured to perform aberration correction at respective apertures independently of each other,
wherein the corrector is associated with the plate located at the plate location at which the energy value is smallest and/or strength of an electric field adjacent to the plate is greatest and/or a ratio of the energy value to strength of an electric field adjacent to the plate is smallest.

According to a second aspect of the invention, there is provided a charged particle-optical device for projecting a plurality of charged particle beams along respective beam paths towards a sample location, the device comprising:
a charged particle-optical lens assembly configured to manipulate the beams, the lens assembly comprising a plurality of plates each having an array of apertures for passage of beam paths and an array of lenses configured to control lensing at respective apertures; wherein at least one of the plurality of plates is a corrector plate, wherein in the corrector plate the lensing comprises aberration correction.

According to a third aspect of the invention, there is provided a method for controlling a charged particle-optical device so as to project a plurality of charged particle beams along respective beam paths towards a sample location, the method comprising:
manipulating the beams with a charged particle-optical lens assembly comprising a plurality of plates each having a plurality of apertures for passage of the beam paths, the plates located at different plate locations along the beam paths;
controlling the charged particle-optical device such that charged particles of the beams have different energy values at the different plate locations along the beam paths; and
performing aberration correction at respective apertures independently of each other with a plurality of individual correctors of a corrector,
wherein the corrector is associated with the plate located at the plate location at which the energy value is smallest and/or strength of an electric field adjacent to the plate is greatest and/or a ratio of the energy value to strength of an electric field adjacent to the plate is smallest.

According to a fourth aspect of the invention, there is provided a method for controlling a charged particle-optical device so as to project a plurality of charged particle beams along respective beam paths towards a sample location, the method comprising:
controlling lensing of the beams at respective apertures of a corrector plate of a charged particle-optical lens assembly with an array of lenses of the corrector plate;
wherein the lensing comprises aberration correction.

According to a fifth aspect of the invention, there is provided a charged particle-optical device for projecting a plurality of charged particle beams along respective beam paths towards a sample location, the device comprising:
a charged particle-optical lens assembly configured to manipulate the beams, the lens assembly comprising a plurality of plates each having an array of apertures for passage of beam paths, the plates located at different plate locations along the beam paths; and
a controller configured to control the charged particle-optical device such that in use the plates at the different plate locations along the beam paths are controllable to have different applied potentials;
wherein the lens assembly comprises a corrector comprising a plurality of individual correctors configured to perform aberration correction at respective apertures independently of each other,
the plurality of plates comprising an associated plate, wherein the corrector is associated with the associated plate and the associated plate is:
   a. the most down beam plate of the assembly or
   b. the most up beam plate of two plates of the assembly having the greatest applied potential difference.

### BRIEF DESCRIPTION OF FIGURES

The above and other aspects of the present disclosure will become more apparent from the description of exemplary embodiments, taken in conjunction with the accompanying drawings.
**FIG.** 1 is a schematic diagram illustrating an electron beam inspection apparatus.
**FIG. 2** is a schematic diagram illustrating a multi-beam electron-optical apparatus that is part of the electron beam inspection apparatus of **FIG. 1****.**
**FIG. 3** is a schematic diagram of a multi-beam electron-optical device.
**FIG. 4** is a schematic diagram of an electron-optical device comprising a macro collimator and macro scan deflector.
**FIG. 5** is a schematic diagram of a multi-beam electron-optical device.
**FIG. 6** is a schematic diagram of part of the multi-beam electron-optical device of **FIG. 5****.**
**FIG. 7** is a schematic cross-sectional view of an objective lens array of an electron-optical device.
**FIG. 8** is a schematic cross-sectional view of a control lens array and an objective lens array of an electron-optical device.
**FIG. 9** is a schematic cross-sectional view of a control lens array and an objective lens array of an electron-optical device.
**FIG. 10** is a schematic cross-sectional view of a control lens array and an objective lens array of an electron-optical device.
**FIG. 11** is a schematic cross-sectional view of a control lens array and an objective lens array of an electron-optical device.
**FIG. 12** is a schematic cross-sectional view of an Einzel lens array of an electron-optical device.
**FIG. 13** is a schematic cross-sectional view of an Einzel lens array of an electron-optical device.
**FIG. 14** is a schematic diagram of part of a corrector of an electron-optical device.
**FIG. 15** is a schematic diagram of part of the corrector shown in **FIG. 14****.**
**FIG. 16** is a bottom view of a modification of a detector of an electron-optical device.
**FIG. 17** is an enlarged schematic cross-sectional view of a detector of an electron-optical device.
**FIG. 18** is a bottom view of a detector element of a detector.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal electrons such as secondary electrons. The detection apparatus captures the signal electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. Similarly, a sub-beam may be referred to as a beam. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons. For example, reference to an electron-optical apparatus may be more generally considered to be reference to a charged particle-optical apparatus.

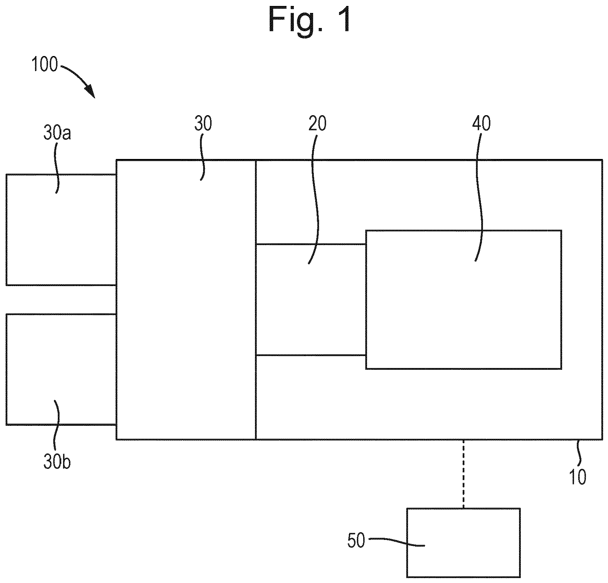

Reference is now made to **FIG. 1**, which is a schematic diagram illustrating an exemplary electron beam inspection apparatus 100. The electron beam inspection apparatus 100 of **FIG. 1** includes a main chamber 10, a load lock chamber 20, an electron-optical apparatus 40 (which may also be called an electron assessment apparatus or an electron beam system or tool), an equipment front end module (EFEM) 30 and a controller 50. The electron apparatus-optical 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron-optical apparatus 40 by which it may be inspected.

The controller 50 is electronically connected to electron-optical components of an electron-optical device of the electron optical apparatus 40. The controller 50 may be a processor (such as a computer) configured to control the electron beam inspection apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it can be distributed over at least two of the component elements. The controller may be considered to be part of the electron-optical apparatus 40; the controller may be considered to be part of the electron-optical device. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

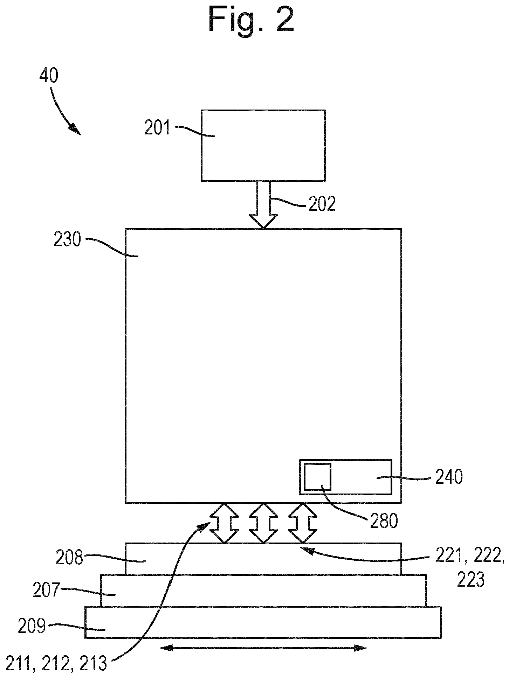

Reference is now made to **FIG. 2**, which is a schematic diagram illustrating an exemplary electron-optical apparatus 40, comprising a multi-beam electron-optical device, that is part of the exemplary electron beam inspection apparatus 100 of **FIG. 1****.** The electron-optical apparatus 40 comprises an electron source 201 and a projection apparatus 230. The electron-optical apparatus 40 further comprises an actuated stage 209 and a support 207 (which may also be referred to as a sample holder). The projection apparatus 230 may comprise an electron-optical device which may be referred to as an electron-optical column. The support 207 is supported by the actuated stage 209 so as to hold a sample 208 (e.g., a substrate or a mask) for inspection. The electron-optical apparatus 40 may further comprise a detector 240 (e.g. an electron detection device).

The electron source 201 may comprise a cathode (not shown) and an extractor or anode (not shown). During operation, the electron source 201 is configured to emit electrons from the cathode 121. The electrons are extracted or accelerated by the extractor and/or the anode 122 to form a primary electron beam 202.

The projection apparatus 230 is configured to convert the primary electron beam 202 into a plurality of sub-beams 211, 212, 213 (also referred to as primary sub-beams) and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the electron beam inspection apparatus 100 of **FIG. 1**, such as the electron source 201, the detector 240, the projection apparatus 230, and the actuated stage 209. The controller 50 may perform various image and signal processing functions. The controller 50 may also generate various control signals to govern operations of the electron beam inspection apparatus 100, including the multi-beam electron-optical apparatus 40.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the sub-beams 211, 212, and 213 to scan the probe spots 221, 222, and 223 across individual scanning areas in a section of the surface of the sample 208. In response to incidence of the sub-beams 211, 212, and 213 on the probe spots 221, 222, and 223 on the sample 208, electrons are generated from the sample 208 which include secondary electrons and backscattered electrons, i.e. examples of signal electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the sub-beams 211, 212, and 213. As an electron detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam electron apparatus 40 such as the detector 240 (as shown in **FIG. 2**). However, the signal processing system 280 may be incorporated into any components of the electron beam inspection apparatus 100 or multi-beam electron apparatus 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof.

The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the electron-optical apparatus 40 and electron beam inspection apparatus 100 described above, are disclosed in US2020118784, US20200203116, US 2019/0259570 and US2019/0259564 which are hereby incorporated by reference.

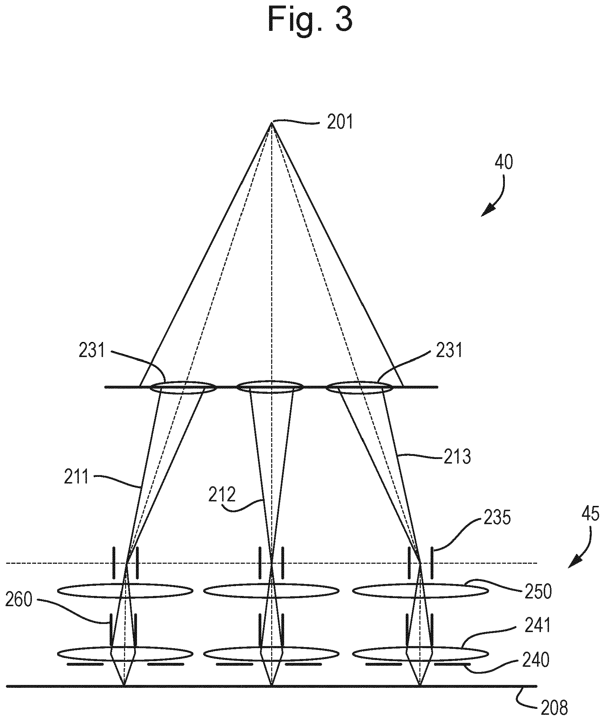

Components of an electron-optical apparatus 40 which may be used in the present invention are described below in relation to **FIG. 3** which is a schematic diagram of part of an electron-optical apparatus 40. **FIG. 3** depicts an electron-optical device of an electron-optical apparatus 40. An electron-optical apparatus 40 may comprise the electron-optical device and a motorized or actuated stage 209. The electron-optical device of **FIG. 3**, with an actuated stage to support sample 208, may correspond to the electron-optical apparatus 40 (which may also be referred to as a system or a tool) mentioned above or later herein.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an electron beam, for example from the source, into a plurality of sub-beams, with the array providing a lens for each sub-beam. Each condenser lens in the condenser lens array may be for operating on a sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

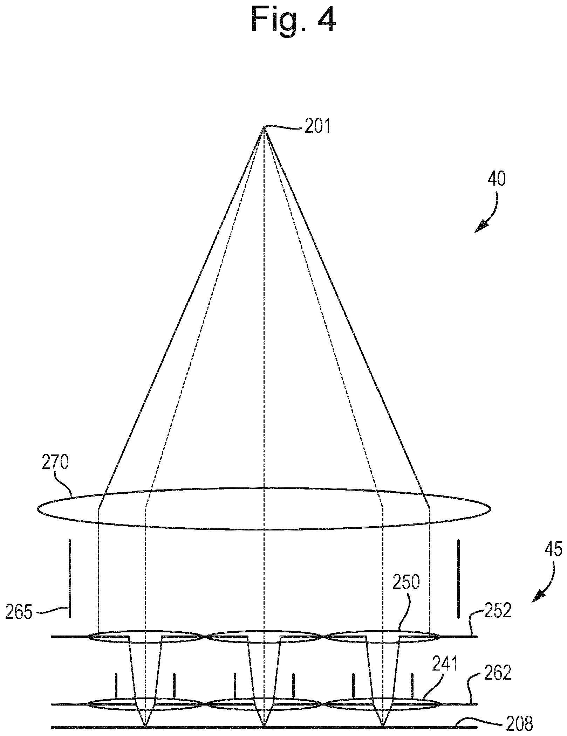

Each condenser lens 231 in the array directs electrons into a respective sub-beam 211, 212, 213 which is focused at a respective intermediate focus down beam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4**), instead of, or in addition to the deflectors 235. Thus, the macro collimator 270 described below in relation to **FIG. 4** may be provided with the features of FIG. 3. This is generally less preferred than providing the collimator array as deflectors 235.

Below (i.e. down beam or further from electron source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

The objective lenses of the objective lens array 241 can be configured to demagnify the electron beam, for example, by a factor greater than 10, desirably in the range of 50 to 100 or more. The objective lenses may be Einzel lenses. At least the chromatic aberrations generated in a beam by a condenser lens and the corresponding downbeam objective lens may mutually cancel.

In an embodiment a detector 240 is associated with the objective lens array, for example provided between the objective lens array 241 and the sample 208 signal particles, for example to detect secondary and/or backscattered electrons emitted from the sample 208. An exemplary construction of the detector 240 is described below.

Optionally, an array of scan deflectors 260 is provided between the control lens array 250 and the objective lens array 241. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

**FIG. 4** is a schematic diagram of an exemplary electron device comprising a macro collimator 270 and a macro scan deflector 265. The electron source 201 directs electrodes toward a macro collimator 270. The electron source 201 is desirably a high brightness thermal field emitter with a good compromise between brightness and total emission current.

Sub-beams may be derived from the beam, for example, using a sub-beam forming array 252 (also known as a beam limiting aperture array) defining an array of beam-limiting apertures. The beam may separate into the sub-beams on meeting the control lens array 250, described below. The sub-beams are substantially parallel on entry to the control lens array 250.

The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). Thus the path of each sub-beam is at least intended to be orthogonal to the surface of the sample 208. The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro collimator may be at least partially implemented electrostatically. The macro collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro collimator 270 may be partially or wholly replaced by a collimator element array provided down-beam of the sub-beam forming array. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up beam of the control lens array 250. The collimator element array may be in the same module as the control lens array 250.

As shown in **FIG. 4**, in an embodiment the electron-optical device comprises an objective lens array 241. The objective lens array 241 comprises a plurality of objective lenses. The objective lens array 241 may be an exchangeable module. The exchangeable module may feature other electron-optical elements such as a detector array and/or a control lens array.

Below (i.e. down beam or further from the electron source 201) the macro collimator 270 there is a control lens array 250. The control lens array 250 is configured to apply a focusing action to the sub-beams prior to the sub-beams reaching the objective lens array. The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. Additionally or alternatively, the control lenses in the control lens array 250 are configured to control the opening angle of the sub-beams and/or to control demagnification (i.e. magnification) of the sub-beams and/or to control landing energy.

The control lens array 250 may be as described above in relation to **FIG. 3****.**

In the embodiment of **FIG. 4** a macro scan deflector 265 is provided to cause sub-beams to be scanned over the sample 208. The different sub-beams correspond to different portions of the beam across the multi-beam path, up-beam of the generation of the sub-beams. The macro scan deflector 265 deflects respective portions of the beam. The deflection of the portions of the beam causes the sub-beams corresponding to the respective portions to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan deflector array comprises a plurality of scan deflectors. The scan deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

In some embodiments, the electron-optical device further comprises a sub-beam forming array 252. The sub-beam forming array 252 defines an array of beam-limiting apertures. The sub-beam forming array 252 may be referred to as an upper beam-limiting aperture array or up-beam beam-limiting aperture array. The sub-beam forming array 252 may comprise a plate (which may be a plate-like body) having a plurality of apertures. The sub-beam forming array 252 forms sub-beams from a beam of electrons emitted by the source 201. Portions of the beam other than those contributing to forming the sub-beams may be blocked (e.g. absorbed) by the sub-beam forming array 252 so as not to interfere with the sub-beams down-beam. The sub-beam forming array 252 may be referred to as a sub-beam defining aperture array or an upper beam limiter. The apertures of the sub-beam forming array 252 may have a diameter of at least 10 µm, optionally at least 20 µm, optionally at least 50 µm, optionally at least 100 µm, and optionally 120 µm. The apertures have a pitch that may by equal to that of the apertures of the beam apertures 406.

In some embodiments, as exemplified in **FIG. 4**, the electron-optical device comprises an objective lens array assembly, which is a unit that comprises the objective lens array 241. The objective lens array assembly may comprise a beam shaping aperture array 262. The beam shaping aperture array 262 defines an array of beam-limiting apertures. The beam shaping aperture array 262 may be referred to as a lower beam limiter, lower beam-limiting aperture array or final beam-limiting aperture array. The beam shaping aperture array 262 may shape beams defined by an upper beam limiter 252. The use of two shaping aperture arrays is beneficial in situations in which use of just the upper beam limiter 252 risk introducing aberrations into the beams. The beam shaping aperture array 262 is closer to the sample 208. The use of the beam shaping aperture array 262 beneficially helps to reduce if not remove such aberrations. The performance of such beam shaping aperture array 262 may improve with proximity to the sample 208. The beam shaping aperture array 262 may comprise a plate (which may be a plate-like body) having a plurality of apertures. The beam shaping aperture array 262 may be down-beam from at least one electrode (optionally from all electrodes) of the control lens array 250. In some embodiments, the beam shaping aperture array 262 is down-beam from at least one electrode (optionally from all electrodes) of the objective lens array 241.

In an arrangement, the beam shaping aperture array 262 is structurally integrated with an electrode of the objective lens array 241. The beam shaping aperture array 262 and the electrode may be connected to substantially the same potential. The beam shaping aperture array 262 and the electrode may then have the same beam energy. They have zero potential difference with respect to each other, and the same potential difference for example with respect to a reference potential, such as a ground potential. Desirably, the beam shaping aperture array 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping aperture array 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

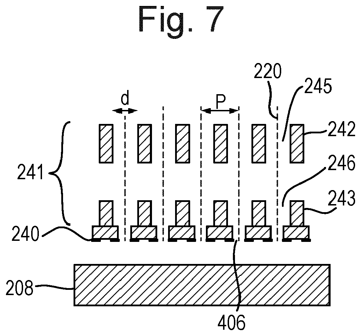

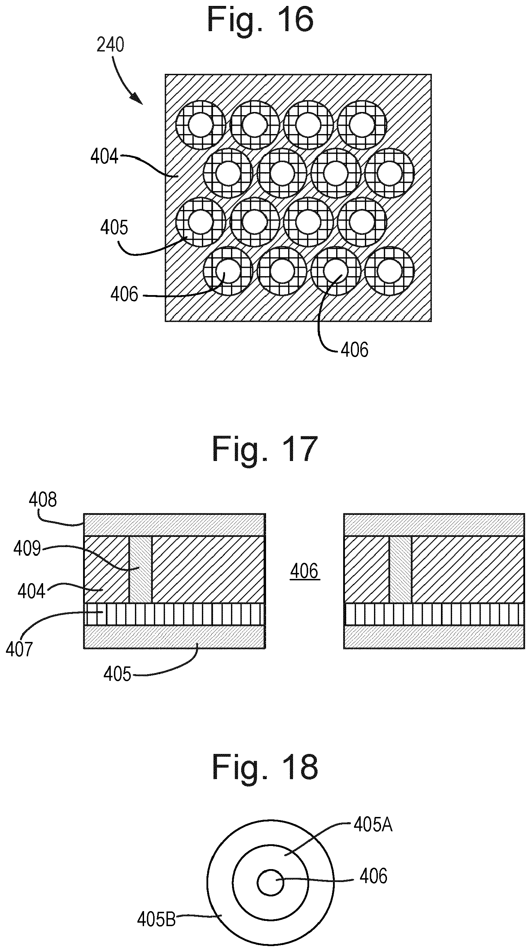

Any of the electron-optical apparatuses 40 described herein may further comprise a detector 240. The detector 240 detects electrons emitted from the sample 208. The detected electrons may include any of the electrons detected by an SEM, including secondary and/or backscattered electrons emitted from the sample 208, which may be types of signal electron. An exemplary construction of a detector 240 is shown in **FIG. 7** and described in more detail below with reference to **FIGs. 16-18****.**

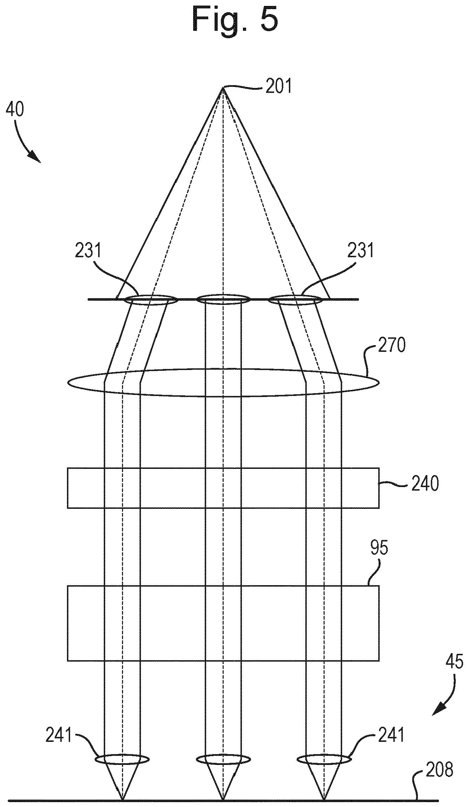

**FIG. 5** schematically depicts an electron-optical device according to an embodiment. Features that are the same as those described above are given the same reference numerals. For conciseness, such features are not described in detail with reference to **FIG. 5****.** For example, the source 201, the macro collimator 270, the objective lens array 241 and the sample 208 may be as described above. Note that macro collimator 270 may have an associated deflector array. The deflector array may be used to for fine collimation. The deflector array may be located down beam of the macro-collimator. The macro collimator may have an array of individually controllable deflectors for fine correction of the beams of the multi-beam array.

In an embodiment the electron-optical device comprises an array of condenser lenses 231, or at least a beam limiting aperture array. (In an arrangement the macro-collimator may be located up-beam of the condenser lens array, or at least the beam limiting array.) The array of condenser lenses 231 (or at least the beam limiting aperture array) generates a plurality of sub-beams from the incidental beam from the source 201. (Note if the array of condenser lenses 231 is the beam limiting aperture array without any lensing function, the lensing function may be undertaken by the macro condenser 270). There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. In an embodiment, the objective lens may have four or more plates which may function as electrodes.

As described above, in an embodiment the detector 240 is between the objective lens array 241 and the sample 208. The detector 240 may face the sample 208. Alternatively, as shown in **FIG. 5**, in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the signal particles such as secondary electrons from the sample 208.

In an embodiment the detector 240 is configured to detect signal particles by reference to the energy of the electron, i.e. dependent on a band gap. Such a detector 240 may be called an indirect current detector. The signal electrons emitted from the sample 208 gain energy from the fields between the electrodes. The signal electrons have sufficient energy once they reach the detector 240.

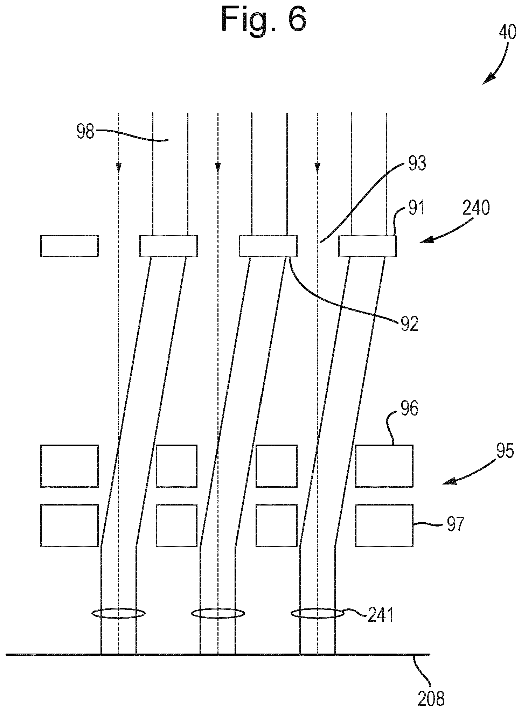

**FIG.** 6 is a close-up view of part of the electron-optical device shown in **FIG.** 5. In an embodiment the detector 240 comprises an electron to photon converter array 91. The electron to photon converter array 91 comprises a plurality of scintillator elements such as fluorescent strips 92. Each fluorescent strip 92 is located in the plane of the electron to photon converter array 91. At least one fluorescent strip 92 is arranged between two adjacent electron beams projected towards the sample 208.

In an embodiment, the fluorescent strips 92 extend substantially in the horizontal direction (or orthogonal to the paths of the sub-beams). Alternatively, the electron to photon converter array 91 may comprise a plate of a fluorescent material with openings 93 for the projected electron beams.

The projected electron beams, indicated by dashed lines in **FIG. 6**, are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected electron beams transmitted towards the sample 208. Accordingly, the projected electron beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding signal electrons created in the sample 208 towards the deflector array 95. For the signal electrons, which travel in opposite direction with respect to the projected electron beams, the electrostatic deflector 97 does not counteract the deflection of the magnetic deflector 96. Instead, the deflections of the signal electrons by the electrostatic deflector 97 and the magnetic deflector 96 add up. Accordingly, the signal electrons are deflected to travel at an angle with respect to the optical axis in order to transmit the secondary electrons onto the fluorescent strips 92 of the detector 240.

At the fluorescent strips 92, photons are created upon incidence of the signal electrons such as secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

As mentioned above, in an embodiment the electron-optical device comprises an electron-optical lens assembly. For example as described with reference to **FIG. 4**, in an embodiment the electron-optical device comprises an objective lens assembly 45 which is an electron-optical lens assembly comprising the objective lens array 241. As another example the electron-optical device may comprise a condenser lens assembly which is an electron-optical lens assembly comprising the condenser lenses 231, for example as described with reference to and as depicted in **FIG. 3****.** In an embodiment the present invention is applicable to an electron-optical device comprising an electron-optical lens assembly. Embodiments of the present invention are described below primarily with reference to an objective lens assembly as the electron-optical lens assembly. The present invention is equally applicable to arrangements in which a condenser lens assembly is the electron-optical lens assembly.

As explained above in an embodiment the electron-optical device is for projecting a plurality of electron beams along respective beam paths towards a sample location. The electron-optical device comprises an electron-optical lens assembly. The electron-optical lens assembly is configured to manipulate (e.g. focus and/or condense) the beams. For example an objective lens assembly 45 may be configured to focus the beams onto the sample 208. As another example a condenser lens assembly may be configured to condense the beams up-beam of the objective lens array 241 (for example focus the beams towards a respective intermediate focus, for example a plane of intermediate foci array for the multi-beam arrangement or multi-beam array.

In an embodiment the electron-optical lens assembly comprises a plurality of plates each having an array of apertures for passage of beam paths. The plates are located at different plate locations along the beam paths. This is described in more detail below, with particular focus on the example of an objective lens assembly as the electron-optical lens assembly. It should be understood that the teaching is applicable to a condenser lens assembly configured to condense the beams instead of focusing the beams onto a sample.

The objective lens assembly 45 comprises the objective lens array 241. The objective lens array 241 of any embodiment may comprise at least two electrodes in which are defined aperture arrays. In other words, the objective lens array comprises at least two electrodes with a plurality of holes or apertures. **FIG.** 7 shows electrodes 242, 243 which are part of an exemplary objective lens array 241 having respective aperture arrays 245, 246. The electrodes 242, 243 may be formed as plates. The plates may be lens plates configured to perform a lensing function. The position of each aperture in a plate corresponds to the position of a corresponding aperture in another plate. The corresponding apertures operate in use on the same beam, sub-beam or group of beams in the multi-beam. In other words, corresponding apertures in the at least two plates are aligned with and arranged along a sub-beam path, i.e. one of the sub-beam paths 220. Thus, the plates are each provided with apertures through which the respective sub-beam 211, 212, 213 propagates.

The objective lens array 241 may comprise two electrodes, as shown in **FIG. 7****,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

Adjacent plates of the objective lens array 241 are spaced apart from each other along the sub-beam paths. The distance between adjacent plates, in which an insulating structure might be positioned, is larger than the objective lens.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the electron beam by a factor greater than 10, desirably in the range of 50 to 100 or more.

A detector 240 is provided to detect signal electrons for example secondary and/or backscattered electrons emitted from the sample 208. The detector 240 is positioned between the objective lens array 241 and the sample 208. The detector 240 may otherwise be referred to as a detector array or a sensor array, and the terms "detector" and "sensor" are used interchangeably throughout the application.

The array of objective lenses (i.e. the objective lens array 241) may correspond with the array of detectors (i.e. the detector 240) and/or any of the beams (i.e. the sub-beams). The detector 240 may be an array of detector elements, each of which may be associated with an aperture in the plates of the objective lens array 241.

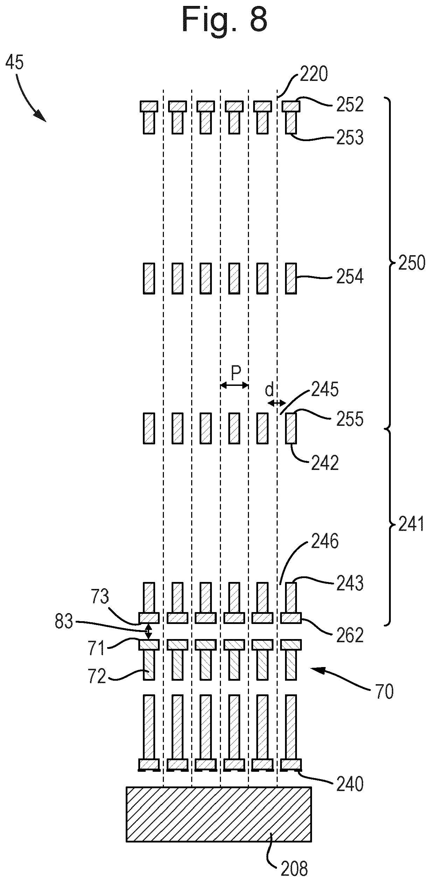

**FIG. 8** is a schematic view of part of the electron-optical device of, for example, **FIG. 4** viewed in cross-section. The part of the electron-optical device may be referred to as an objective lens assembly 45. **FIG. 8** shows a close-up view of the objective lens array 241 and the control lens array 250. As shown in **FIG. 8****,** in an embodiment the beam shaping aperture array 262 is associated with the objective lens array 241. The beam shaping aperture array 262 may be down-beam of the objective lens array 241. For example, the beam shaping aperture array 262 may comprise a plate that is attached to an electrode of the objective lens array 241, preferably the down-beam electrode 243 of the objective lens array 241. The plate of the beam shaping aperture array 262 may be integrally formed with an electrode of the objective lens array 241, desirably the down-beam electrode 243 of the objective lens array 241. The plate of the beam shaping aperture array 262 may be comprised as part of the of the beam shaping aperture array 262. Alternatively, the beam shaping aperture array 262 may be distanced from the objective lens array 241. The beam shaping aperture array 262 may be formed as a separate component from any of the electrodes 242, 243 of the objective lens array 241.

As shown in **FIG. 8**, in an embodiment the beam shaping aperture array 262 is down-beam of the objective lens array 241. In an alternative embodiment the beam shaping aperture array 262 is further up-beam, such as even up-beam of the objective lens array 241. For example, the beam shaping aperture array 262 may be connected to or formed integrally with the up-beam electrode 242 of the objective lens array 241. In an embodiment the beam shaping aperture array 262 is located between the objective lens array 241 and the control lens array 250.

As shown in **FIG. 8**, the control lens array 250 is associated with the objective lens array 241. As described above, the control lens array 250 may be considered as providing electrodes additional to the electrodes 242, 243 of the objective lens array 241. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens.

As shown in **FIG. 8**, in an embodiment the control lens array 250 and the objective lens array 241 share a common electrode. In the arrangement shown in **FIG. 8**, the control lens array 250 comprises three electrodes 253, 254, 255. In an embodiment the down-beam electrode 255 of the control lens array 250 and the up-beam electrode 242 of the objective lens array 241 form a common electrode. The same conductive plate may be used for both the down-beam electrode 255 of the control lens array 250 and the up-beam electrode 242 of the objective lens array 241. The common electrode arrangement allows for a particularly compact objective lens assembly. In an alternative embodiment the down-beam electrode 255 of the control lens array 250 is distanced from the up-beam electrode 242 of the objective lens array 241. The electrodes of the control lens array 250 may be separate from the electrodes of the objective lens array 241.

In the arrangement shown in **FIG. 8**, the control lens array 250 comprises three electrodes 253, 254, 255. In alternative embodiment, the control lens array 250 may comprise one electrode or two electrodes, for example. Each additional plate or electrode of the control lens may enable the control lens array 250 to have an additional degree of freedom.

In an embodiment the controller 50 is configured to control the voltage applied to the intermediate electrode 254 and the down-beam electrode 255 of the control lens array 250 in order to adjust the focus of the incoming sub-beams.

In an embodiment the controller 50 is configured to control the objective lenses of the objective lens array 241 to operate as decelerating lenses. The controller 50 may control the voltages applied to the electrodes 242, 243 of the objective lens array 241 such that the objective lenses decelerate the electrons of the sub-beams that are projected toward the sample 208. The controller 50 is configured to adjust the voltages applied to the electrodes 242, 243 during use of the electron-optical apparatus 40.

In an embodiment the sub-beam forming array 252 is configured to split an electron beam into the multi-beam of electrons comprising the sub-beams. Thus the sub-beam forming array 252 generates sub-beams of the multi-beam of electrons from an electron beam, for example, from the electron source 201.

In the arrangement shown in **FIG. 8**, the sub-beam forming array 252 is associated with the control lens array 250. For example, the sub-beam forming array 252 may be associated with the up-beam electrode 253 of the control lens array 250. In an embodiment the sub-beam forming array 252 provides a most up-beam electrode 252 of the control lens array 250. For example, the sub-beam forming array 252 may comprise a plate that is connected to or is integrally formed with the up-beam electrode 253. In an alternative embodiment, the sub-beam forming array 252 is provided as a physically separate component from the electrodes 253, 254, 255 of the control lens array 250.

As shown in **FIG. 8**, in an embodiment the sub-beam forming array 252 is up-beam of the control lens array 250. As shown in **FIG. 8**, in an embodiment the electron-optical device comprises the detector 240. The detector 240 may be formed as a detector array comprising a plurality of detector elements 405 (see **FIGs. 16-18**) at a position along the beam path configured to detect signal particles emitted from the sample 208. For example, the detector array may be the most down-beam element in the electron-optical device. In use the detector array may face a sample. In an embodiment the detector elements 405 are associated with respective sub-beams of the multi-beam of electrons.

In an embodiment the controller 50 is configured to control the electron-optical apparatus 40 to operate to detect signal particles emitted by the sample 208. As shown in **FIG. 8**, the apertures of the beam shaping aperture array 262 are dimensionally smaller than the respective apertures of the control lens array 250. The beam shaping aperture array 262 having dimensionally smaller apertures enables the beam shaping aperture array 262 to shape the beams down-beam of their generation by the sub-beam forming array 252. The beam shaping aperture array 262 provides the limiting factor for the current of electrons of the sub-beams that is projected toward the sample 208. During inspection, the beam shaping aperture array 262 is preferably proximate the sample 208 is configured to shape (e.g. limit) the sub-beams.

In some embodiments, a corrector comprising one or more aberration correctors are provided that reduce one or more aberrations in the sub-beams. The one or more aberration correctors may be provided in any of the embodiments, e.g. as part of the electron-optical device, and/or as part of an optical lens array assembly, and/or as part of an assessment system. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up-beam or down-beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment (i.e. in other words preventing a proper alignment in the electron-optical device). Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that at or near the condenser lenses the sub-beams each have relatively large cross-sectional areas and relatively small pitch at this location, relative to locations further down-beam. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 relative to, for example over, the sample 208. In an embodiment, the scanning deflectors described in US 2010/0276606, which document is hereby incorporated by reference in its entirety, may be used.

In an embodiment the electron-optical device comprises a controller 50. In an embodiment the controller 50 is configured to control the electron-optical device such that in use electrons of the beams can have different energy values at the different plate locations along the beam paths. Optionally adjoining plates can be controlled to have the same beam energy (for example arrangements in which the most down-beam electrode of the control lens array is the same as the most up-beam electrode of the objective lens array). Additionally or alternatively, in an embodiment the controller 50 is configured to control the electron-optical device such that in use the plates at the different plate locations along the beam paths are controllable to have different applied potentials.

The energy value at a plate location is the energy of an electron of a beam at the plate location, i.e. as the electron passes through the aperture of the plate at the plate location. The energy value is proportional to the electrical potential difference between the plate and the cathode of the electron source 201. The greater the electrical potential difference, the greater the energy value. The beam energy is the energy the electrons have at that specific plate. It equals the potential difference between that plate and the cathode. The electric field follows from the potential difference to the neighboring plate, divided by their spacing, e.g.. the displacement along the shortest path between the plate and the neighboring plate.

In an embodiment the controller 50 is configured to control the energy values at the plate locations. The controller is configured to control the energy values at the plate locations by controlling the electrical potential applied to the plate and/or to the cathode.

**FIG. 8** schematically depicts an objective lens assembly 45 of an electron-optical device. As shown in **FIG. 8**, in an embodiment the objective lens assembly 45 comprises a corrector 70. In an embodiment the corrector 70 comprises a plurality of individual correctors. The individual correctors are configured to perform aberration correction at respective apertures independently of each other. An individual corrector corresponds to a respective aperture. The respective apertures may be defined in a plate (or corrector plate). The individual corrector is individual to the respective aperture. The individual corrector is configured to perform aberration correction at the respective aperture independently of any aberration correction performed by the individual correctors of other apertures. The individual correctors may be comprised in the plate. The plate may comprise an individual corrector at or even around the respective aperture of the individual corrector.

In an embodiment the individual correctors are configured to perform correction of astigmatism at the respective aperture. The individual corrector may be a stigmator. The individual corrector may be referred to as an individual beam stigmator. In an embodiment the electron-optical device is configured such that a plurality of beam paths pass through the aperture at which an individual corrector is configured to perform aberration correction. In such an arrangement the individual corrector may be a multiple beam stigmator configured to correct for astigmatism of a plurality of beams at the respective aperture. The individual corrector may be configured to manipulate the cross-sectional shape of one or more beams having beam paths that pass through the respective aperture. For example, in an embodiment the individual corrector is configured to make the one or more beams more circular.

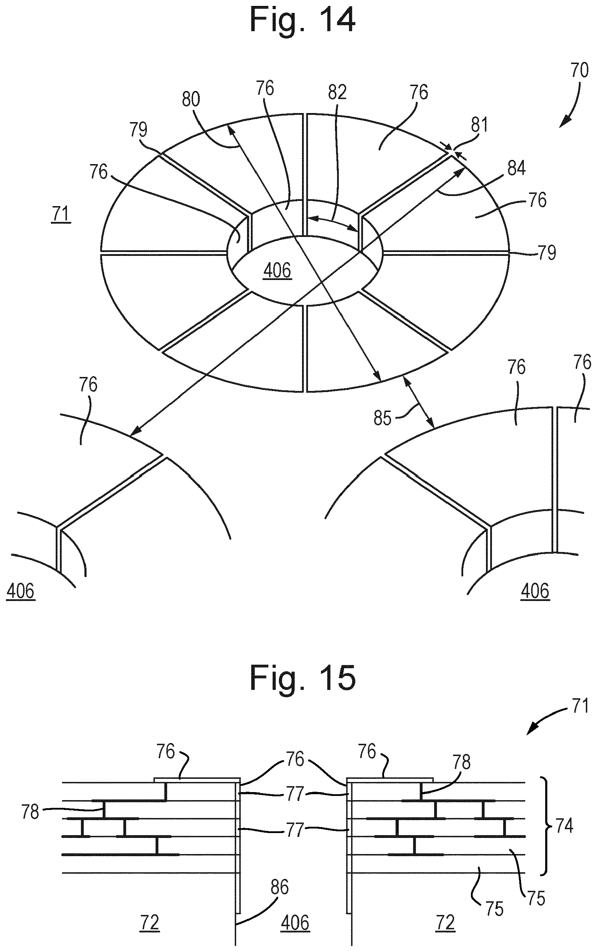

Additionally or alternatively the corrector 70 is configured to perform correction by any order or multipoles such 2 pole, 4 pole, 6 pole, 8 pole or any other higher order pole corrector. Such a multipole corrector is described in more detail particularly with reference to FIG. 14.

By performing aberration correction, it is possible to compensate for manufacturing imperfections of the electron-optical device. For example, the lens plates of the electron-optical device may be imperfectly shaped causing the electron beams to be imperfectly shaped. An embodiment of the invention is expected to achieve an increase in the tolerance for imperfections of the lens plates. For example the tolerance of the diameters of apertures and/or the ellipticity of apertures and/or the alignment of the centers of apertures of different plates may be increased. The ellipticity or two fold astigmatism (for example of a four pole disturbance) may be corrected using a four pole corrector for example a corrector with four electrodes or four groups of electrodes. Further multiple fold astigmatism may be corrected, for example correcting: an eight pole disturbance (or four fold astigmatism) or squareness using an eight pole corrector (or a corrector with eight electrodes or eight groups of electrodes); or a six pole disturbance (or three fold astigmatism) or triangleness for example using a six pole corrector (e.g. a corrector with six electrodes or six groups of electrodes).

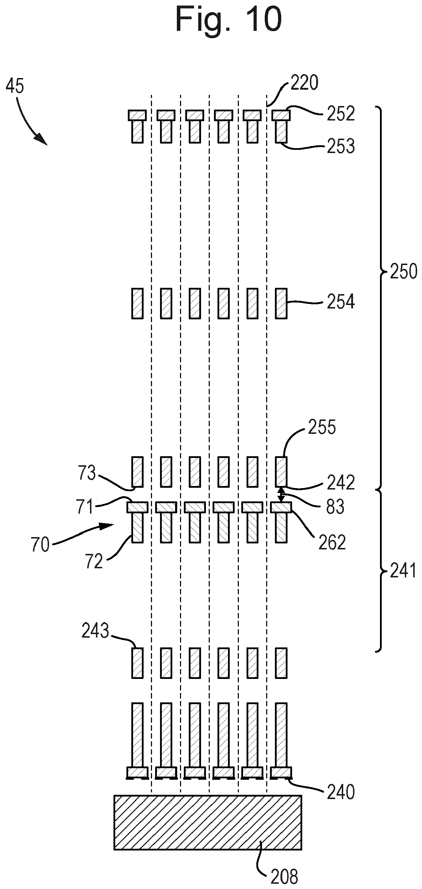

In an embodiment one of the plates of the electron-optical lens assembly is an associated plate. As shown in **FIG. 8**, in an embodiment the corrector 70 is associated with the associated plate of the electron-optical lens assembly. The associated plate is the plate with which the corrector 70 is associated. The associated plate and at least the substrate of the corrector 70 may be connected to a common potential difference to have the same beam energy, or a substantially common potential difference with respect to a reference potential such as the ground potential. The associated plate and the corrector 70 may be separate, for example not in contact with each other. In the arrangement shown in **FIG. 8**, the associated plate is the lens plate that forms the down-beam electrode 243 of the objective lens array 241. In alternative embodiments the associated plate may be a plate of the electron-optical assembly other than the electrode 243, as described with reference to **FIGs. 10-13**, for example.

In an embodiment the associated plate is the plate located at the plate location at which the beam energy value (or beam energy more informally 'energy value') is smallest. In an embodiment the objective lens array 241 shown in **FIG. 8** is a decelerating lens array. The beam energy may be lowest at the down-beam electrode 243. The beam energy at the down-beam electrode may be substantially equal to the energy of the electrons when they are incident on the sample 208 (i.e. the landing energy).

By providing that the corrector is associated with the plate at which the beam energy is low, the strength of the corrector 70 may be high. The strength of the corrector 70 means the extent to which an individual corrector affects the electron beam at the respective aperture for a given voltage applied to the individual corrector. By increasing the strength of the corrector 70, the voltage required to be applied to the individual corrector in order to perform a given aberration correction may be reduced. By reducing the voltage required to be applied to the individual corrector, the space required to accommodate the individual corrector may be reduced. For example, electrodes of the individual corrector may be reduced in size, desirably the length of the electrodes of the individual corrector for example along the beam path, desirably parallel to the beam path, and/or at least partly through the corrector plate. The required length of the electrodes may be reduced from having to extend through the entire corrector plate. An embodiment of the invention is expected to achieve an increased strength of aberration corrector. The strength of the aberration corrector may be improved at despite reducing the length of the electrodes. In an embodiment, as described later herein, elements of the circuitry to control the electrodes of the individual correctors may be reduced. For example circuit elements such as transistors such as for generating control voltages for the electrodes such as within the detector array may be reduced. This is desirable because it enables more of the circuitry to be located in situ, proximate to the associated detector element. Shorter electrode lengths in the direction of the beam path, and smaller electronic components which can be included in the body or substrate of the corrector enables use of a layered structure such as CMOS as is later herein described.

It is not essential for the associated plate to be located at the plate location at which the energy value is smallest. Alternatively, the associated plate may be located at the plate location at which strength of an electric field adjacent to the plate is greatest and/or a ratio of the energy value to strength of an electric field adjacent to the plate is smallest.

Additionally or alternatively, in an embodiment the associated plate is the plate located at the plate location at which strength of an electric field adjacent to the plate is greatest. In the arrangement shown in **FIG. 8**, the electric field up-beam of the down-beam electrode 243 is greater than the electric field between any other plates of the objective lens assembly 45 and optionally of the electron-optical device. The electric field may be great in order to focus the beams onto the sample 208. For completeness it is noted that the electric field immediately down-beam of the down-beam electrode 243 is low and optionally substantially zero. The field down-beam of the detector 240 accelerates the secondary electrons originating from the sample 208 towards the detector 240; the field down-beam of the detector 240 is therefore more than zero and may not be low.

By ensuring that the beam size may be smaller the associated plate has a stronger adjacent electric field. That is, the associated plate provides a relatively strong lens because the field is high and the beam energy is low. So the beam size is ensured to be small at the associated plate so as to limit the aberrations caused by the lens. A position in the beam path proximate to the associated plate is a desirable location to locate the corrector. The beam size is the cross-sectional area of the beam in a plane perpendicular to the direction of the beam, i.e. the plane of the plate. For example, in the arrangement shown in **FIG. 8** the size of the apertures at the corrector 70 may be approximately equal to the sum of the size of the apertures of the beam shaping aperture array 262 and a tolerance value for alignment. By providing that the beam size is smaller at the corrector 70, the apertures associated with the individual correctors can be small for a given filling percentage. The filling percentage is the percentage of the cross-sectional diameter of an aperture that is filled by the electron beam(s) having beam path(s) through it. By providing that the apertures can be smaller, the strength of the corrector 70 can be increased. An embodiment of the invention is expected to achieve an increased strength of aberration corrector.

It is not essential for the associated plate to be located at the plate location at which strength of an electric field adjacent to the plate is greatest. Alternatively, the associated plate may be located at the plate location at which the energy value is smallest and/or a ratio of the energy value to strength of an electric field adjacent to the plate is smallest.

Additionally or alternatively, in an embodiment the associated plate is the plate located at the plate location at which a ratio of the energy value to strength of an electric field adjacent to the plate is smallest. The plate that has the smallest ratio of the energy value to strength of an electric field adjacent to the plate may be referred to as the strongest plate.

In the example shown in **FIG. 8**, the down-beam electrode 243 is the strongest plate of the objective lens assembly 45 and optionally of the electron-optical device. By providing that the corrector 70 is associated with the strongest plate, the strength of the corrector 70 may be increased. An embodiment of the invention is expected to achieve an increased strength of aberration corrector.

It is not essential for the associated plate to be located at the plate location at which a ratio of the energy value to strength of an electric field adjacent to the plate is smallest. Alternatively, the associated plate may be located at the plate location at which the energy value is smallest and/or strength of an electric field adjacent to the plate is greatest.

As shown in **FIG. 8** in an embodiment the corrector 70 is associated with the associated plate by comprising a corrector plate 72 located adjacent to the associated plate. In an embodiment the corrector 70 comprises a corrector electrode side 71. The corrector electrode side 71 of the corrector 70 is the side of the corrector plate 72 at which electrodes of the individual correctors are located. In the example shown in **FIG. 8**, the corrector plate 72 is located adjacent to the down-beam electrode 243. The corrector plate 72 is separate from the associated plate. In the example shown in **FIG. 8** the corrector 70 is located directly down-beam of the objective lens array 241.

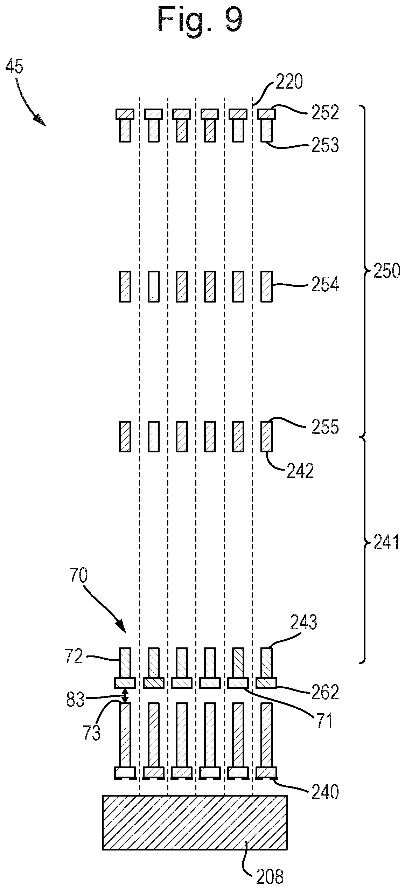

As described in more detail later with reference to **FIG. 9**, it is possible for the corrector 70 to be integrated into a lens plate rather than the corrector 70 being a separate element. By providing that the corrector 70 is a separate element from the lens plates, the objective lens assembly 45 may be easier to manufacture. The corrector plate 72 is configured to provide the correction function. The associated plate is configured to function as the down-beam electrode 243 of the objective lens array 241 and desirably as the beam shaping aperture array 262. By providing the corrector 70 as a separate element, the number of functions combined in a single plate is reduced. An embodiment of the invention is expected to make it easier to manufacture the electron-optical device.

As shown in **FIG. 8**, in an embodiment the objective lens assembly 45 comprises a detector 240. In an embodiment the detector 240 is at a potential difference at or close to ground potential, for example in the range of 0 to 200 V, for example 20 to 100 V, such as 30 to 50 V. The ground potential may be considered a reference potential for the entire apparatus, so that the ground potential is the ground with respect to the apparatus. In an embodiment the corrector 70 may be provided at or close to the ground potential for example in the range of 0 to 200 V, for example 20 to 100 V, such as 30 to 50 V. Of course the individual correctors of the corrector 70 may comprise electrodes to which electrical potentials are applied (e.g. voltages of the order of about 5 V to 20 V, for example enabling use of CMOS architecture). In an embodiment the electrical potentials are applied relative to ground potential (i.e. electrical potentials within about 5V of ground). This may be advantageous compared to applying electrical potentials relative to a non-ground potential. An embodiment of the invention is expected to make it easier to electrically connect the electrodes of the corrector 70 for controlling the applied electrical potentials. In an alternative embodiment the corrector 70 is provided at a controlled potential different from ground, for example at a beam energy with the source at close to ground.

As shown in **FIG. 8**, in an embodiment the corrector plate 72 is located such that its nearest plate of the electron-optical lens assembly is the associated plate. In the arrangement shown in **FIG. 8**, the two plates that are adjacent to the corrector plate 72 are those of the down-beam electrode 243 and the detector 240. In an embodiment the distance between the corrector plate 72 and the down-beam electrode 243 (for example when comprising the beam shaping aperture array 262) is less than the distance between the corrector plate 72 and the detector 240. In an arrangement in which the plate of the beam shaping aperture array 262 is spaced down-beam of the down-beam electrode 243, the distance to consider is the distance between the corrector plate and the plate of the beam shaping aperture array 262.

In an alternative embodiment the distance between the corrector plate 72 and the detector 240 may be reduced so as to reduce the distance between the objective lens array 241 and the sample 208. By reducing the distance between the objective lens array 241 and the sample 208, the electron-optical performance may be improved. The focal length of the objective lens becomes shorter desirably increasing the strength of the objective lenses of the objective lens array 241. However, the proximity of the sample to a most proximate surface of the electron-optical device, which in the depicted arrangement may be the detector array 240, may limit the proximity between the sample and the electron-optical device that may be achieved, for example 5 to 100 micron, such as 30 to 60 micron.

It should be noted that in any arrangement having a beam shaping aperture array 262, the following components and functions should be present: a beam shaping aperture array 262, individual correctors in a corrector electrode side 71 of a corrector 70, a shield plate 73 (which is introduced with respect to **FIG. 9** as described below) and a lens electrode, which with respect to the embodiment shown in and depicted by **FIG. 9** is down-beam electrode 243. As will be appreciated from the arrangements shown in and described with reference to **FIGs. 8-13****,** the position along the path of the beams may be different, and some functions may be of the same element and/or of different sides of the same element.

**FIG. 9** is a schematic diagram of an electron-optical assembly having an alternative arrangement to that shown in **FIG. 8****.** Many features of the objective lens assembly 45 shown in **FIG. 9** are the same as those of the objective lens assembly shown 45 in **FIG. 8** and described with reference to **FIG.** 8. For example, the sub-beam forming array 252, the electrodes 253, 254, 255 of the control lens array 250 and the detector 240 of the objective lens array shown in **FIG. 9** may be the same as described with reference to **FIG. 8****.** Such features will not be described again so as to avoid redundant repetition. Instead, the description of the objective lens assembly 45 shown in **FIG. 9** primarily relates to the differences compared to the objective lens assembly shown 45 in **FIG. 8****;** the description of the same features of **FIG. 8** is hereinto referenced.

As shown in **FIG. 9** in an embodiment the corrector 70 is associated with the associated plate by being integrated into the associated plate. For example the corrector 70 may be monolithically integrated into the associated plate. The corrector and the associated plate may be connected, desirably by a common connection, to a generally common potential difference, for example with respect to a reference potential such as ground potential. In the arrangement shown in **FIG. 9** the associated plate is the plate that forms the down-beam electrode 243 of the objective lens array 241. The corrector 70 is integrated into the plate of the down-beam electrode 243. That is, the associated plate is the corrector plate; the associated plated is an integrated corrector plate or integrated plate. Integrating the corrector plate into the associated plate may be desirable because the associated plate and the corrector may be located at the same position along the beam paths. The electric field and beam energy may be selected with respect to the integrated plate, so may simultaneously be with respect to both the corrector plate and the associated plate. The full strength of the lens is generated by the associated plate, so the corrector is positioned in the beam path where the cross-section of the beams are optimally small. Note there is a limit in view of the required distance between the electron-optical device, for example the detector facing the sample position; the lens should not be too strong else the focus of the of the lens would be above, or up-beam of, the sample.

As shown in **FIGs. 8-9** in an embodiment the corrector 70 comprises a corrector electrode side 71. The corrector electrode side 71 of the corrector 70 is the side of the corrector plate 72 at which electrodes of the individual correctors are located. In an embodiment the corrector plate 72 comprises a substrate. The electrodes of the individual correctors may be located at the corrector electrode side 71 of the substrate of the corrector plate 72.

In the arrangement shown in **FIG. 9** the corrector electrode side 71 is at a down-beam side of the down-beam electrode 243. The lenses of the objective lens array 241 are formed by the down-beam surface of the up-beam electrode 242 and the up-beam surface of the down-beam electrode 243. The lensing function of the objective lens array 241 and the aberration correction function of the corrector 70 are associated with different surfaces of the same plate of the objective lens array. It should be noted that the surfaces of the up-beam electrode 242 and the down-beam electrode 243 that provide the lensing function of the objective lens array 241 are the same as for the arrangement shown in and described with reference to **FIG. 8****.** The beam shaping aperture array 262 shown in and described with reference to **FIG. 9****,** for example being comprised in the down-beam electrode 243 or in a separate plate associated with and down-beam of the down-beam electrode 243, may have the same function and properties as the beam shaping aperture array depicted in and described with reference to **FIG. 8****.** However, the beam shaping aperture array 262 additionally comprises the corrector electrode side 71 comprising the individual correctors.

By integrating the corrector 70 into the associated plate, the height of the electron-optical lens assembly may be reduced. This may be advantageous. For example the electron-optical device may be more compact. As another example in the arrangement shown in **FIG. 9**, the distance between the objective lens array 241 and the sample 208 may be reduced. By reducing the distance between the objective lens array 241 and the sample 208, the electron-optical performance of the electron-optical device may be improved. For example, as described with reference to the arrangement described with reference to **FIG. 8**, the strength of the lens may increase.

In an embodiment the associated plate performs a lensing function at the apertures of the associated plate. In an embodiment the individual correctors of the corrector 70 are configured to provide all of the lensing function of the associated plate. For example in the arrangement shown in **FIG. 9** all of the lensing function of the down-beam electrode 243 is provided by the electrodes of the individual correctors of the corrector 70.

In the arrangement shown in **FIG. 9**, the associated plate combines the functions of the down-beam electrode 243 of the objective lens array 241, the beam shaping aperture array 262 and the corrector 70. An embodiment of the invention is expected to reduce the number of separate elements of the electron-optical device while providing a high strength aberration corrector.

In an embodiment the controller 50 is configured to control electric potentials of the plates of the electron-optical assembly. The control of the electric potential of the plates of the electron-optical assembly is such that in use beam width perpendicular to the beam paths varies among the plate locations. This is depicted schematically in **FIGs. 3-4** for example. In an embodiment the associated plate is located at the plate location at which the beam width is smallest for example to shape the cross-section of the beams. For example, in the arrangement shown in **FIGs. 8-9** the beam width may be smallest at the down-beam electrode 243 of the objective lens array 241.

By providing that the beam width is smaller at the corrector 70, the apertures associated with the individual correctors can be small for a given filling percentage. The filling percentage is the percentage of the cross-sectional area of an aperture that is filled by the electron beam(s) having beam path(s) through it. By providing that the apertures can be smaller, the strength of the corrector 70 can be increased. An embodiment of the invention is expected to achieve an increased strength of aberration corrector. The beam shaping aperture array as shown in and described with reference to **FIGs.** 8-9 may be both designed to achieve this objective. Yet, as noted in comparing these two arrangements, the arrangement of **FIG. 8** has the beam shaping aperture array in a separate element from the corrector 70, whereas the arrangement of **FIG. 9** has the beam shaping aperture array in the same element as the corrector 70. It may be desirable for the individual correctors and thus the corrector electrode side 71 to be positioned down-beam of the beam shaping aperture array 262; to achieve the beam shaping aperture array 262 to be up-beam of the individual correctors, a single element may be used in the arrangement of **FIG. 9**, whereas two elements are required in the arrangement of **FIG. 8****.** Having the beam shaping aperture array 262 up-beam of the individual correctors enables the apertures of the corrector to be small as desired, avoiding illumination of the individual correctors by the electron beams which may increase undesirable risks such as contamination of the individual correctors.

In an embodiment the electron-optical lens assembly is configured to decelerate electrons towards the sample location. As shown in **FIGs. 8-9** in an embodiment the associated plate is at a down-beam end of the electron-optical lens assembly.

It is not essential for the associated plate to be at a down-beam end of the electron-optical lens assembly. Alternatives are shown in **FIGs. 10-11****,** for example. **FIG. 10** is a schematic diagram of an electron-optical assembly having an alternative arrangement to that shown in **FIGs**. **8-9****.** Many features of the objective lens assembly 45 shown in **FIG. 10** are the same as those of the objective lens assembly 45 shown in **FIG. 8** and described with reference to **FIG. 8****.** For example, the sub-beam forming array 252, the electrodes 253, 254, 255 of the control lens array 250 and the detector 240 of the objective lens array shown in **FIG. 10** may be the same as described with reference to **FIG. 8****.** Such features will not be described again so as to avoid redundant repetition. Instead, the description of the objective lens assembly 45 shown in **FIG. 10** primarily relates to the differences compared to the objective lens assembly 45 shown in **FIG. 8**; the description of the same features of **FIG. 8** is hereinto referenced.

In an embodiment the electron-optical lens assembly is configured to accelerate electrons towards the sample location. As shown in **FIG. 10**, in an embodiment the associated plate is at is at an up-beam end of the objective lens array 241. In an embodiment the associated plate is at an up-beam end of the electron-optical lens assembly. For example the control lens array 250 may be omitted or may be considered not to form part of the objective lens assembly 45.

When the electron-optical lens assembly is configured to accelerate electrons towards the sample location, the up-beam electrode 242 may be the plate located at the plate location along the beam path at which the energy value is smallest. Additionally or alternatively the up-beam electrode 242 may be the plate located at the plate location along the beam path at which strength of an electric field adjacent to the plate is greatest. Additionally or alternatively the up-beam electrode 242 may be the plate located at the plate location along the beam path at which a ratio of the energy value to strength of an electric field adjacent to the plate is smallest.

In the arrangement shown in **FIG. 10**, the associated plate is the up-beam electrode 242 of the objective lens array 241. The corrector 70 is provided as a corrector plate 72 separate from the up-beam electrode 242. The corrector electrode side 71 faces the up-beam electrode 242. The corrector 70 is located down-beam of the up-beam electrode 242 of the objective lens array 241.

As shown in **FIG. 10**, in an embodiment the corrector plate 72 performs the function that the beam shaping aperture array 262 performs in the arrangement shown in **FIG. 8****.** (Note if the objective lens assembly 45 shown in and described with reference to **FIG. 10** is intended for use in the electron-optical device of the electron-optical apparatus 40 shown in and described with reference to **FIG. 4**, the sub-beam forming array 252 generates the beams 220). In a different embodiment, the beam shaping aperture array is a function of a lens electrode instead of the corrector 70. The beam shaping aperture array 262 may be integrated into the up-beam electrode 242. This arrangement may be desirable over the arrangement depicted in **FIG. 10** because of the risk of illuminating up-beam facing individual correctors. Illumination of an electron-optical device such as the correctors increases the risk of contamination. Contaminated correctors have a reduced life time and may require complex cleaning strategies to maintain the lifetime of the correctors.

In the arrangement shown in **FIG. 10**, the down-beam electrode 243 of the objective lens array is consequently not required to shape the beams (for example considering either arrangement described). The beam shaping aperture array 262 may be omitted from the down-beam electrode 243. Instead the beam shaping aperture array of the corrector plate (the corrector electrode side 71 of the corrector plate 72) shapes the beams. The position of the beam shaping aperture array is moved along the beam path so that, like the corrector array, it is associated with the strongest lensing element of the objective lens array.

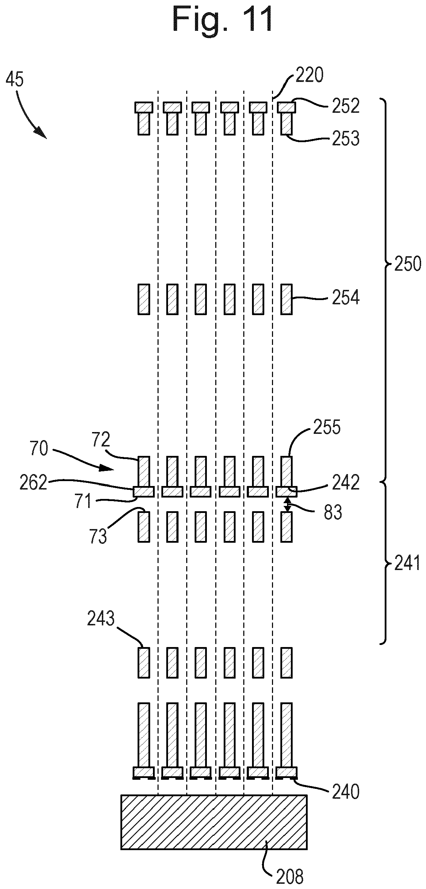

**FIG. 11** is a schematic diagram of an electron-optical assembly having an alternative arrangement to that shown in **FIGs. 8-9**, or even an alternative to the electron-optical assembly as shown in and described with reference to **FIG. 10****.** Many features of the objective lens assembly 45 shown in **FIG. 11** are the same as those of the objective lens assembly 45 shown in **FIG. 8** and described with reference to **FIG. 8****.** For example, the sub-beam forming array 252, the electrodes 253, 254, 255 of the control lens array 250 and the detector 240 of the objective lens array shown in **FIG. 11** may be the same as described with reference to **FIG. 8****.** Such features will not be described again so as to avoid redundant repetition. Instead, the description of the objective lens assembly 45 shown in **FIG. 11** primarily relates to the differences compared to the objective lens assembly 45 shown in **FIG. 8**; the description of the same features of **FIG. 8** is hereinto referenced.

In the arrangement shown in **FIG. 11**, the associated plate is the up-beam electrode 242 of the objective lens array 241. The corrector 70 is integrated into the up-beam electrode 242. The corrector electrode side 71 is at the down-beam surface of the up-beam electrode 242.

As shown in **FIG. 11**, in an embodiment the beam shaping aperture array 262 is integrated into the corrector plate 72. The beam shaping aperture array 262 is provided in the same component as the corrector 70. The beam shaping aperture array provides the corrector electrode side 71 in a plate positioned down-beam of the corrector plate in the beam path. The beams are shaped up beam of the individual correctors. The individual correctors face down-beamwards. In an alternative arrangement (not depicted) the beam shaping aperture array is down-beam of the corrector plate 72. The risk of contamination of the correctors is reduced in facing away from the beams projected towards the sample position. The beam shaping aperture array 262 shapes the beams as the beam shaping aperture array 262 performs in the arrangement shown in **FIG. 8****.** In the arrangement shown in **FIG. 11**, the down-beam electrode 243 of the objective lens array is not required to shape the beams. The beam shaping aperture array 262 may be omitted from the down-beam electrode 243. Thus the beam shaping aperture array 262 is positioned along the beam path so that the corrector array is associated with the strongest lensing element of the objective lens array.

In the arrangement shown in **FIG. 11** all of the lensing function of the up-beam electrode 242 is provided by the electrodes of the individual correctors of the corrector 70.

In the arrangement shown in **FIG. 11**, the associated plate combines the functions of the down-beam electrode 255 of the control lens array 250 (for example provided by an up-beam surface of the down-beam electrode 243), the up-beam electrode 242 of the objective lens array 241) and the corrector 70. An embodiment of the invention is expected to reduce the number of separate elements of the electron-optical device while providing a high strength, for example correcting, aberration corrector.

As mentioned above, in an embodiment the electron-optical lens assembly is configured to decelerate electrons towards the sample 208. In an alternative embodiment the electron-optical lens assembly is configured to accelerate electrons towards the sample 208. Such electron-optical assemblies may be used as objective lens assemblies as shown in **FIGs**. **8-11**, for example. Additionally or alternatively such electron-optical assemblies may form the condenser lenses 231 shown in **FIGs. 3-5**, for example. When forming the condenser lenses 231, the control lens array 250, the detector 240 and the beam shaping aperture array 262 shown in **FIGs. 8-11** may be omitted. (Note in a condenser lens assembly, a beam forming array, which is generally the most up-beam element of a condenser lens assembly, generates the beams and thus shapes the beams.)

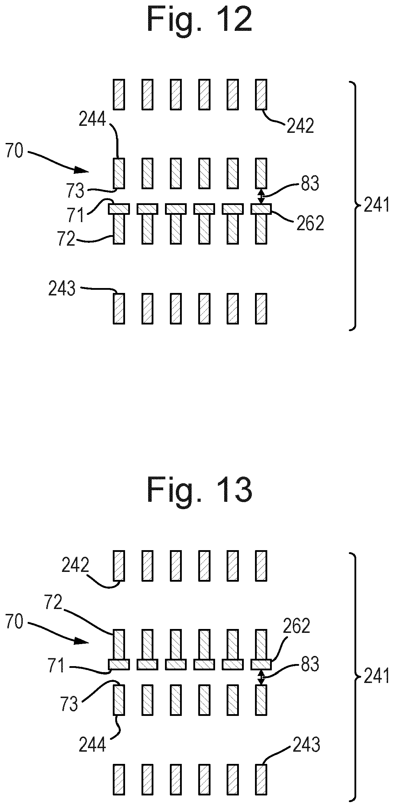

It is not essential for the electron-optical lens assembly to either accelerate or decelerate electrons towards the sample 208. In an alternative embodiment the electron-optical lens assembly is an Einzel lens assembly. This is shown in **FIGs. 12-13**, for example. A condenser lens in a condenser lens assembly may comprise such an Einzel lens assembly. An objective lens assembly may comprise an Einzel lens assembly as an objective lens, for example with one or more of beam shaping aperture array 262, a detector array 240, a control lens array 250 and a beam forming array 252.

**FIG. 12** is a schematic diagram of an electron-optical assembly which is an Einzel lens assembly. Such an electron-optical assembly may comprise the condenser lenses 231 shown in **FIGs.** 3-5, for example. Alternatively such an electron-optical assembly may be used as an objective lens array 241, as shown in **FIGS. 12-13****.** Many features of the objective lens assembly featuring an objective lens array 241 shown in **FIGS. 12-13** are the same as those of the objective lens assembly shown in **FIG. 8** and described with reference to **FIG. 8****.** For example, the sub-beam forming array 252, the electrodes 253, 254, 255 of the control lens array 250 and the detector 240 of the objective lens array shown in and described with reference to **FIG. 8** may be the combined with the features if either **FIGs. 12-13****.** Such features will not be described again so as to avoid redundant repetition. Instead, the description of the objective lens assembly shown in **FIGs. 12-13** primarily relates to the differences compared to the objective lens assembly 45 shown in **FIG. 8**; the description of the same features of **FIG. 8** is hereinto referenced.

The Einzel lens assembly comprises three plates corresponding to the three electrodes 242, 243, 244. As shown in **FIG. 12** in an embodiment the associated plate is an intermediate plate of the Einzel lens assembly. In the arrangement shown in **FIG. 12** the intermediate plate forms the intermediate electrode 244 of the objective lens array 241. In an Einzel lens the intermediate plate may be the strongest lens plate. By providing that the corrector 70 is associated with the intermediate plate, the strength of the corrector may be generally increased. An embodiment of the invention is expected to increase the strength of an aberration corrector.

In the example shown in **FIG. 12** the corrector 70 is provided as a corrector plate 72 separate from the intermediate electrode 244. The corrector 70 is located down-beam of the intermediate electrode 244. The individual correctors of the corrector 70 may be located in a field free region, for example on a corrector electrode side 71 of the corrector plate, for example down-beam of the intermediate electrode 244. In such an arrangement, the corrector electrode side 71 of the corrector plate 72 may function as the beam shaping aperture array 262 to shape the beams. In another embodiment, the field free region is associated with the surface of the intermediate electrode 244. In such an arrangement, the beam shaping aperture array is integrated in the intermediate electrode for example in a surface of the intermediate electrode 244 facing the corrector electrode side of the corrector plate 72. Note: a field free region is provided when two electron-optical elements along the beam path have a common potential. The two electron-optical elements have substantially zero potential difference; they have the same beam energy..

In the alternative example shown in **FIG. 13** the corrector 70 is provided as a corrector plate 72 separate from the intermediate electrode 244. The corrector 70 is located up-beam of the intermediate electrode 244. The individual correctors of the corrector 70 may be located in a field free region, for example on a corrector electrode side 71 of the corrector plate, for example up beam of the intermediate electrode 244. In such an arrangement, the corrector electrode side 71 of the corrector plate 72 may function as the beam shaping aperture array 262 to shape the beams. In another embodiment, the field free region is associated with the surface of the intermediate electrode 244; for example the beam shaping aperture array 262 faces up-beam towards the corrector electrode side 71 of the corrector array 72 In such an arrangement, the beam shaping aperture array is integrated into, or at least associated with, the intermediate electrode for example in a surface of the intermediate electrode 244 facing the corrector electrode side of the corrector plate 72.

In an embodiment the electron-optical lens assembly is comprised in a stack. The stack comprises a plurality of plates stacked relative to each other. The stack may be a stack of layers. The layers may comprise the plates. The stack may comprise isolating spacers between adjacent plates in the stack. The plates may be mechanically connected and/or integrated in the stack for example by the isolating spacers. In an embodiment the stack is an electron-optical stack for example comprising electron-optical elements or plates. As described later herein, the electron-optical element arrays may be a MEMS in the form of a plate. In an embodiment the corrector 70 is mechanically integrated into the stack. The corrector may be a layer within the stack. The corrector 70 is a mechanically stable part of the electron-optical assembly. In an alternative embodiment the corrector 70 is provided separate from the stack. For example the corrector plate 72 shown in **FIG. 8** may be provided separately from a stack that comprises the down-beam electrode at its down-beam end, desirably as its down-beam most surface.

In an embodiment the corrector 70, at least the side of the corrector comprising the individual correctors (for example the corrector electrode side 71) is located in a region defined between components at substantially the same electric potential. In an embodiment the corrector 70, at least the corrector electrode side 71, is located in a region substantially free of electric fields. The field free nature of the region of the corrector 70 can help to reduce the possibility of aberrations caused by such electric fields. For example, as shown in and described with reference to **FIG. 9**, the corrector electrode side 71 of the corrector 70 (that comprises the multipole electrode 262) that corresponds to the beam shaping aperture array 262 is in a substantially field free region. However, the other side of the corrector, the up-beam side of the down-beam electrode 243 of the objective lens 241, of the arrangement of **FIG. 9** is in a region having a high field. Note: the field free region is defined with respect to the overall field between the surface of the corrector electrode side 71 and a facing electron element which in **FIG. 9** is shield plate 73, except for the correcting fields generated by the individual correctors which are required to generate a field to operate. However, the size of the potential required to operate the correctors is low because of the strength of the lens generated by the associated plate, such that the perturbation of the individual correctors can be considered to be small if not negligible. Thus the field free region is substantially field free.

Although a beam shaping aperture array has been described in each of the embodiments shown in and described with reference to **FIGs. 8-13**, it is noted that this disclosure is for an objective lens assembly 45 in combination with a macro-condenser lens as shown in and described with reference to **FIG. 4****.** Such an arrangement benefits from a beam shaping aperture array because the change in beam path through the macro-condenser lens array during scanning of the beam may be mitigated by reshaping the beam proximate to the sample. In an electron-optical device such as shown in and described with reference to **FIG. 3** or **FIG. 5**, a beam shaping aperture array is not required in addition to the beam forming array which is usually present in the condenser lens array 231. Such an arrangement does not require a second shaping proximate the sample, because the nature of the beam should not vary as in the arrangement of electron-optical device shown in and described with reference to **FIG. 4****.** Further the apertures of the correctors, although desirably small, operate on the beams without shaping, limiting or blocking any part of the cross-sections of the beams.

As shown in **FIGs. 8-13** in an embodiment the electron-optical device comprises a shield plate 73. The shield plate 73 is arranged to face the corrector 70, specifically the corrector electrode side 71 of the corrector, i.e. the individual correctors. The shield plate 73 is arranged to face the corrector electrode side 71 of the corrector 70. Distance 83 is between the facing surface so the corrector 70 and shield plate 73. The distance 83 should be as short as possible between the corrector 70 and the shield plate 73 (and without touching and so without shorting). If distance 83 is larger, the corrector becomes stronger, but there is a limit because if distance 83 is too long, the risk of cross-talk increases. The distance 83 therefore cannot be too large. The shield plate 73 is configured to shield the corrector 70 from electric fields which could otherwise cause unwanted aberrations. From the perspective of the electric fields generated by the individual correctors, the shield has two components up-beam and down-beam of the individual correctors: the shield plate 73 and the substrate of the corrector on which the individual correctors are located. The shield plate 73 provides a well-defined endpoint of the electrode field generated by the individual correctors of the corrector 70, for example in the corrector electrode side 71 of the corrector 70. The field generated by the relatively thin corrector electrodes of the individual correctors is shielded on one side by the shield plate 73. On the other side of the corrector electrodes along the beam paths, the electric field is provided with another well-defined end point by the substrate on which the electrodes of the individual beam corrector are, for example formed or fabricated

In an embodiment the shield plate 73 is formed by one of the plates of the electron-optical lens assembly. In the plate of the shield plate 73 may be defined apertures that desirably have a regular, for example circular cross-sectional shape and that are aligned with apertures in other plates of the stack such as multipole electrodes of the individual correctors. However if the shield has an elliptical aperture or an aperture which is shifted relative the aperture of another plate in the stack, multipole errors are introduced, which can be corrected by setting proper voltages on the different poles of the multipole corrector. However, reliable fabrication of the regular apertures is achievable.

In an embodiment the shield plate 73 is a beam limiting aperture array for example a beam shaper array. As shown in **FIG. 8** in an embodiment the plate that functions as the down-beam electrode 243 of the objective lens array 241 and the beam shaping aperture array 262 is configured to function as the shield plate 73. The shield plate 73 is located up-beam of the corrector 70.

It is not essential that the shield plate 73 is formed by one of the plates of the electron-optical lens assembly. In an embodiment the electron-optical device comprises a detector array for detecting signal electrons from the sample location. As shown in **FIG. 9** in an embodiment the substrate associated with the detector 240 (e.g. detector array) is configured to function as the shield plate 73. The shield plate 73 is located down-beam of the corrector 70. The surface of the detector array 240 which functions as the shield plate is the up-beam surface of the detector array 240, whereas the down-beam surface of the detector array comprises detector elements.

As shown in **FIG. 10** in an alternative embodiment the plate that functions as the down-beam electrode 255 of the control lens array 250 and the up-beam electrode 242 of the objective lens array 241 is configured to function as the shield plate 73. The shield plate 73 is located up-beam of the corrector 70.

As shown in **FIG. 11** in an alternative embodiment a separate plate is provided as the shield plate 73. The shield plate 73 is located down-beam of the corrector 70. The shield plate 73 may comprise or be associated with a beam shaping aperture array 262. The beam shaping aperture array may be provided in the up-beam surface of the shield plate 73, desirably facing the corrector electrode side 71 of the corrector 70.

As shown in **FIG. 12** in an alternative embodiment the plate that functions as the intermediate electrode 244 of the objective lens array 241 is configured to function as the shield plate 73. The shield plate 73 is located up-beam of the corrector 70. In an arrangement the shield plate may comprise a beam limiting aperture array 262 which may be provided by the down-beam surface of the shield plate 73; alternatively the beam limiting aperture array may be provided by the corrector electrode side 71 (or corrector side 71) of the corrector plate 72 desirably facing the intermediate electrode 244.

As shown in **FIG. 13** in an alternative embodiment the plate that functions as the intermediate electrode 244 of the objective lens array 241 is configured to function as the shield plate 73. The shield plate 73 is located down-beam of the corrector 70. In an arrangement the shield plate 73 may comprise a beam limiting aperture array 262 which may be provided by the up-beam surface of the shield plate 73 desirably facing the corrector electrode side of the corrector 72; alternatively the beam limiting aperture array 262 may be provided by the corrector electrode side 71 of the corrector plate 72 desirably facing the intermediate electrode 244.

In an embodiment the shield plate 73 comprises portions extending perpendicular to the beam path corresponding to respective apertures of the corrector 70. In an embodiment the portions are rotationally symmetric about an axis of the beam path passing through the respective apertures of the corrector 70. The rotational symmetry provides apertures with circular cross-sections as commented above. The rotational symmetry helps to reduce unwanted aberrations that may be caused by asymmetry in a surface facing the corrector electrode side 71 of the corrector 70. For example, the sample 208 may have a surface which is not rotationally symmetric about the beam paths. A shield plate 73 having rotationally symmetric portions can reduce any unwanted aberrations that could otherwise be caused by the sample 208.

As shown in **FIG. 14** in an embodiment the corrector 70 is provided with multiple electrodes around an aperture. The aperture may define a through path through the corrector. The through path may define a path for an electron-optical beam. The corrector 70 may have circumferential gaps 79 defined in between adjacent electrodes 76. The circumferential gaps and electrodes may not have rotational symmetry, but reflective symmetry. The reflective symmetry may be of positions that are segments relative to the geometrical axis of the corrector through-path. The corrector 70 is configured to perform correction by any order of multipoles such 2 pole, 4 pole, 6 pole, 8 pole or any other higher order pole corrector. The corrector 70 may be configured to perform correction of one or more aberrations such as off axis aberrations such as astigmatism and position (i.e. inter beam alignment or intra-multibeam array alignment).

In an embodiment the shield plate 73 is configured to reduce crosstalk between the individual correctors. Cross talk may occur when one individual corrector undesirably affects one or more beams having beam paths extending through an aperture other than the aperture that the individual corrector is associated with (e.g. provided at). Typically cross talk is caused by an adjoining beam in the multi-beam array. An embodiment of the invention is expected to improve the accuracy of aberration correction.

In an embodiment a surface of the shield plate 73 is in a region substantially free of electric field, desirably a surface of the shield plate 73 that faces the corrector that is desirably in the corrector electrode side 71. Note the exception for the fields generated by the individual correctors themselves. Thus, the field free region is substantially field free. For example the shield plate 73 may be a lens plate. The surface of the lens plate (shield plate 73) that is in a substantially electric field free region may face away from another plate of the electron-optical lens assembly, an electric field being between the shield plate 73 and the other plate. For example, as shown in **FIG. 8** in an embodiment the shield plate 73 is the down-beam electrode 243 of the objective lens array 241. The surface in the substantially field free region is the down-beam surface of the down-beam electrode 243 and which is the shield plate 73 which faces away from the up-beam electrode 242; there is an electric field present between the shield plate 73 and the up-beam electrode 242.

As another example, as shown in **FIG. 10** the shield plate 73 is the down-beam electrode 255 of the control lens array 250. The surface of the down beam electrode 245 in the field free region is the down-beam surface of the down beam electrode 255 of the control lens (which may be referred to as the down-beam surface of the up-beam electrode 242 of the objective lens array 241). The down-beam surface of the up-beam electrode 242 faces away from the intermediate electrode 254 of the control lens array, there being an electric field between the shield plate 73 and the intermediate electrode 254.

As another example, as shown in **FIG. 11** in an embodiment the shield plate 73 can be considered to be an intermediate electrode 244 of the objective lens array 241. The up-beam surface of the intermediate electrode 244, which may be referred to as the shield plate 73 is in a substantially electric free field region. Thus the down-beam surface of the up-beam electrode 242 of the objective lens array that is in the field free region faces away from the up-beam electrode 242. However an electric field region is between the down-beam surface of the shield plate 73 (or intermediate electrode 244) and the down-beam electrode 243.

In another example, as shown in **FIG. 13** the shield plate 73 is the intermediate electrode 244 of the objective lens array 241. The surface of the shield plate 73 that is in a substantially free of electric field region is the up-beam surface of the shield plate 73 which faces away from the down-beam electrode 243. Between the shield plate 73 and the down-beam electrode 243 is a region in which there is an electric field.

In an embodiment the shield plate 73 is distanced from the corrector electrode side 71 of the corrector 70 by a distance of at least 5µm, optionally at least 10µm, and optionally at least 20µm. In an embodiment the shield plate 73 is distanced from the corrector electrode side 71 of the corrector 70 by a distance of at most 100µm, optionally at most 50µm, and optionally at most 20µm.

As disclosed in the arrangements shown in and described with reference to **FIGs. 8-13**, all arrangements, at least used in a lens assembly such as the objective lens assembly 45 having a beam shaping aperture array 262, for example as depicted in the arrangement of **FIG. 4**, the objective lens assembly has the following functions some of which may be shared by the same element: a beam shaping aperture array 262, individual correctors in a corrector electrode side 71 of a corrector 70, a lens electrode 242, 243, 244 and a shield plate 73. The facing surface of the shield plate 73 and corrector electrode side 71 form a field free region across a distance 83. It is noted that the same element can provide different functions. For example the opposing faces of an element such as: the lens electrode 243, 244, 245 of **FIGs. 9****,** **11** and **12** which may provide a beam shaping aperture array 262; the corrector electrode side 71 and the beam shaping aperture array 262 of **FIGs. 9****,** **11** and **13****.** Other functions can be on the same sides of different elements, such as the shield plate 73 and the beam shaping aperture array 262 of an alternative embodiment to that of **FIGs. 10** and **12** with the beam shaping aperture array placed in an element different from and up-beam of the corrector 70. Sometimes an element may provide more than two functions, such as: the shield plate 73, beam shaping aperture array 262 and corrector 70 of **FIG. 13**; or the beam shaping aperture array 262, shield plate 73 and a lens electrode such as the bottom lens electrode 243 of **FIG. 8** or the intermediate electrode 244 of **FIG. 12****.** Further the shield may be a function of an element other than a corrector 70, a lens electrode or a beam shaping aperture array, such as a detector 240, for example the up-beam facing surface of the detector 240.

With respect to an arrangement of a lens arrangement, such as an objective lens arrangement 45 as shown in and described with reference to FIGS. 3 and 5, which do not feature a beam shaping aperture array 262 separate from a beam forming array 252, the arrangement may have the functions: a corrector 70, a lens electrode, 242, 243, 244 and a shield plate 73. An element may have more than function which may be achieved by the same surface or the opposite surfaces of the element, such as a corrector electrode side 71 and a bottom lens electrode 243 and a different element featuring a detector 240 and shield plate 73, as depicted in Fig 9.

**FIG. 14** is a schematic diagram showing a close-up view of an individual corrector adjacent to two other individual correctors of the corrector 70. As shown in **FIG. 14** in an embodiment the individual corrector is arranged to surround the respective beam aperture 406. The individual corrector is configured to correct aberration of one or more beams having beam paths through the beam aperture 406.

As shown in **FIG. 14** in an embodiment each individual corrector comprises a plurality of electrodes 76 for a respective beam path. Additionally or alternatively the corrector 70 may referred to as a multipole. The corrector may comprise a plurality of electrodes (or poles) having an even number of members i.e. electrodes or poles. The plurality of electrodes are configured to operate in one or more orders multipoles such as 2 pole, 4 pole, 6 pole, 8 pole or any other higher order pole having an even number. In an embodiment the controller 50 is configured to apply electric potentials to the electrodes 76 so as to control the aberration correction. The multipole corrector may be controlled to compensate for aberrations such as astigmatism using four poles or a number of poles divisible by four; the multipole may be controlled to operate as a deflector having an even number of pole, i.e. at least two poles. The multipole corrector may be configurable to be controlled to correct any feasibly correctable aberration. In an embodiment the controller 50 is configured to control the electric potentials applied to the electrodes 76 independently of each other.

In an embodiment the individual corrector comprises at least 4, optionally at least 8, optionally at least 10 and optionally at least 20 electrodes 76. In an embodiment the electrodes 76 are distributed substantially evenly circumferentially around the beam aperture 406. Alternatively the electrodes may be distributed unevenly. In an embodiment a circumferential gap 79 is provided between adjacent electrodes 76. In an embodiment the circumferential gap 79 is substantially the same between each pair of adjacent electrodes 76. Alternatively the circumferential gap 79 may vary for different pairs of adjacent electrodes 76. In an embodiment the circumferential gap 79 has a gap width 81 of at least 0.5µm, optionally at least 1µm, and optionally at least 2µm. In an embodiment the circumferential gap 79 has a gap width 81 of at most 10µm, optionally at most 5µm and optionally at most 2µm.

As shown in **FIG. 14** in an embodiment at least part of the electrodes 76 is provided at the surface of the corrector electrode side 71 of the corrector 70 substantially perpendicular to the beam paths. As shown in **FIG. 14** in an embodiment at least part of the electrodes 76 is provided at a wall defining the beam aperture 406 and substantially parallel to the beam paths. The electrodes 76 are on and in (i.e. within opposing faces of) the substrate of the corrector plate 72.

In an embodiment the corrector 50 is configured to apply an electric potential of at most 50V, optionally at most 20V, optionally at most 10V, optionally at most 5V, and optionally at most 2V, to the electrodes 76 of the individual corrector.

In an embodiment the maximum diameter 80 across the electrodes 76 is at least 5µm, optionally at least 10µm, optionally at least 20µm, optionally at least 50µm, optionally at least 80 µm, optionally at least 100 µm. In an embodiment the maximum diameter 80 across the electrodes 76 is at most 500 µm, optionally at most 200µm, optionally at most 100µm, optionally at most 50µm and optionally at most 20µm.

In an embodiment the minimum electrode separation 85 between electrodes 76 of adjacent individual correctors is at least 10µm, optionally at least 20µm, optionally at least 50µm, optionally at least 100µm, optionally at least 150 µm, and optionally at least 300 µm. In an embodiment the minimum electrode separation 85 between electrodes 76 of adjacent individual correctors is at most 300 µm, optionally at most 150 µm, optionally at most 100µm, optionally at most 50µm and optionally at most 20µm.

In an embodiment the pitch 84 between adjacent individual correctors is at least 20 µm, optionally at least 50 µm, optionally at least 100 µm, optionally at least 200 µm and optionally at least 500µm. In an embodiment the pitch 84 between adjacent individual correctors is at most 1000 µm, optionally at most 500 µm, and optionally at most 250 µm.

FIG. 15 is a schematic diagram showing a cross-sectional view of an individual corrector at the corrector electrode side 71 of the corrector 70. As shown in **FIG. 15** in an embodiment the corrector 70 comprises a CMOS device. The corrector 70 may be implemented by integrating a CMOS chip corrector into the corrector plate 72 (which may be a lens plate or a separate element) of the electron-optical lens array. That is a CMOS chip may be used to make an electron-optical element having the functions and properties of the corrector plate 72 and optionally a lens electrode such as the intermediate electrode 244, the up-beam electrode 244 of the objective lens array 241 (which may simultaneously be the down-beam electrode 255 of the control lens array), and the down-beam electrode 243 of the objective lens array 243. A CMOS chip has architecture comprising a plurality of conductive layers between which are isolating layers. The conductive layers may be connected to each other through the insulating material using silicon vias.

In an embodiment, the electrodes 76 of the individual correctors are formed in a metal surface layer of the CMOS device. The electrodes 76 can be formed in other layers. Power and control signals of the CMOS may be connected to the CMOS by through-silicon vias 78 for example from an adjoining conductive structure such as an adjoining substrate. For robustness, desirably a passive silicon substrate with holes (e.g. a shield plate 73) shields the CMOS chip from high E-fields (not shown in **FIG. 15**).

As shown in **FIG. 15** the beam aperture 406 is defined by electrodes 76 that surround the beam aperture 406. At a surface of the planar substrate of the corrector plate 72, an electronic control circuit 74 is arranged. In an embodiment the electronic control circuit 74 comprises integrated circuitry which is arranged adjacent to, for example around the beam aperture 406 desirably within the CMOS layers. In this example the electronic control circuit 74 is built up from a plurality of layers 75 with integrated electronic circuitry. The layers 75 are interconnected by vias 78. In an embodiment the corrector plate 72 comprises at least part of the electronic control circuit 74. In an embodiment the inner surface of the corrector plate 72 extends from the part of the electrode 76 perpendicular to the beam paths to the opposing face of the substrate of the corrector plate 72, desirably through the corrector plate 72.

In an embodiment circuitry associated with a detector element within the corrector plate may comprise at least part of the control circuitry of the controller 50 for example the part of the controller associated to the detector element. Components of the controller circuitry in the circuitry layer may include a de-serializer, a digital to analogue converter and an amplifier. In an embodiment at least part of the control circuitry is remote from the corrector plate, desirably remote from the electron-optical device such as external to a vacuum chamber within which the electron-optical device is located.

In an embodiment, at the edge or surface of the beam aperture 406, edge vias 77 are provided. The edge vias 77 are connected to the electrode 76. In an embodiment the edge vias 77 are formed integrally as part of the electrode 76. The edge vias 77 provide an extension of the electrode 76 inside the beam aperture 406 or provide the surface of the through-hole through the corrector plate 72. Thus the electrode 76 of a beam aperture 406 is at least partially arranged against an inward facing wall of the beam aperture 406. The electrode is at least partly provided at a surface into the substrate and on the substrate. The edge vias 77 may be manufactured at the same time and using the same process used for the manufacture of the integrated electronic control circuit 74, desirably using CMOS architecture and using processes for processing CMOS structures.

In an embodiment, each of the beam apertures 406 is provided with a plurality of electrodes 76 arranged around the beam aperture 406 on the substrate of the corrector plate 72. At a distance above the substrate of the corrector plate 72, a shield plate 73 (not shown in **FIG. 15**) may be arranged. The shield plate 73 may also comprises an array of beam apertures 406, which are aligned with the beam apertures 406 of the corrector plate 72.

As shown in **FIG. 15** in an embodiment the electrodes 76 extend along the wall (or surface) of the beam aperture 406 (or through passage through corrector plate 72) further than the layers 75 of the electronic control circuit 74. Alternatively, the electrodes 76 may extend along the wall of the beam aperture 406 substantially the same distance as (or a shorter distance than) the layers 75 of the electronic control circuit 74. As shown in **FIG. 15** in an embodiment an uncovered part 86 of the wall defining the beam aperture 406 is not covered by the electrodes 76. In an embodiment the uncovered part 86 may be recessed relative to the surface of the electrode 76 on the inner surface of the substrate. That is the inner surface through the substrate may be stepped to a larger diameter where the electrode 76 terminates for example within the corrector plate 72, .

In an embodiment the electrodes 76 are formed as a coating at the surface of the substrate. In an alternative embodiment the electrodes 76 are made of doped portions of the substrate of the corrector plate 72. For example the electrodes 76 may be formed of doped silicon.

In an embodiment the controller 50 is configured to control the corrector 70 through a serial bus. In an embodiment the CMOS chip is programmed through the serial bus. This can help to reduce the number of electrical connections required in order to control the corrector 70. An embodiment of the invention is expected to make it easier and/or cheaper to manufacture an electron-optical device with a strong aberration corrector.

In an embodiment the corrector 70 comprises a digital to analogue converter. In an embodiment the digital to analogue converter is configured to convert control signals from the controller 50 into electrode signals to electrodes 76 of the corrector 70. In an embodiment the digital to analogue converter is comprised in a plate comprising the corrector 70. In an embodiment the plate comprising the corrector 70 comprises a plurality of portions to which are assigned respective individual correctors and in which are defined respective apertures 406 and respective digital to analogue converters.

In an embodiment the electron-optical lens assembly comprises a plurality of plates each having an array of apertures for passage of beam paths and an array of lenses configured to control lensing at respective beam apertures 406. In an embodiment at least one of the plurality of plates is a corrector plate 72. In the corrector plate 72 the lensing comprises aberration correction. The function of the aberration correction may be integrated into a lens plate of the electron-optical assembly.

In an embodiment the corrector plate 72 is a lens plate configured to perform a lensing function at the apertures 406. The lenses may be connected to a common controllable electrical potential.

In an embodiment the controller 50 is configured to control the electron-optical device such that in use the plates at the different plate locations along the beam paths are controllable to have different applied potentials. In an embodiment the associated plate is the most down-beam plate of the electron-optical lens assembly, for example as shown in **FIGs. 8-9****.** Alternatively, the associated plate may be the most up-beam plate of two plates of the electron-optical lens assembly having the greatest applied potential difference, for example as shown in **FIGs. 10-11****.**

In an embodiment the corrector 70 is located at the plate location at which the beam energy (or energy value) is smallest and/or strength of an electric field adjacent to the plate is greatest and/or a ratio of the energy value to strength of an electric field adjacent to the plate is smallest.

In an embodiment there is provided a method for controlling an electron-optical device so as to project a plurality of electron beams along respective beam paths towards a sample location. In an embodiment the method comprises manipulating the beams with an electron-optical lens assembly comprising a plurality of plates each having a plurality of apertures 406 for passage of the beam paths, the plates located at different plate locations along the beam paths.

In an embodiment the method comprises controlling the electron-optical device such that electrons of the beams have different energy values at the different plate locations along the beam paths.

In an embodiment the method comprises performing aberration correction at respective apertures 406 independently of each other with a plurality of individual correctors of a corrector 70.

In an embodiment the corrector 70 is associated with the plate located at the plate location at which the energy value is smallest and/or strength of an electric field adjacent to the plate is greatest and/or a ratio of the energy value to strength of an electric field adjacent to the plate is smallest.

In an embodiment there is provided a method for controlling an electron-optical device so as to project a plurality of electron beams along respective beam paths towards a sample location.

In an embodiment the method comprises controlling lensing of the beams at respective apertures 406 of a corrector plate 72 of an electron-optical lens assembly with an array of lenses of the corrector plate 72. In an embodiment the lensing comprises aberration correction.

As described above, the electron-optical apparatus 40 may comprise a detector 240. An exemplary detector 240 is described below. However, any reference to the detector 240 could be a single detector (i.e. at least one detector) or multiple detectors, for example positioned along the multi-beam path, as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIGs. 16-18****.**

The detector 240 may be positioned between the objective lens array 241 and the sample 208. The detector 240 is configured to be proximate the sample 208. The detector 240 may be very close to the sample 208. Alternatively, there may be a larger gap between, the detector 240 and the sample 208. The detector 240 may be positioned in the device so as to face the sample 208. Alternatively, the detector 240 may be positioned elsewhere in the electron-optical device such that part of the electron-optical device that faces the sample 208 is other than, and thus is not, a detector. For example the detector 240 may have a part at least associated with an electrode of the objective lens array 241. For example the detector may be positioned above the objective lens array or even above the objective lens array (i.e. above the control lens array desirably the detector is down beam of a beam forming array 252). The detector array be have any position in the stack of the objective lens assembly 45 desirably in a field free region if it is elsewhere than facing a sample position. Desirably the detector array has multiple element arrays, each element array located at a different position along the path of the multi-beam array such as facing a sample position, up-beam of the objective lens assembly (i.e. up-beam of a control lens array) or another position in the stack of the objective lens assembly for example in a field free region between layers of the stack of an electron-optical element.

For a multi-beam system of the type shown in **FIGs. 2-5**, preferably, a distance between the electron-optical device (or column) and the sample 208 is less than or equal to approximately 50 µm. The distance is determined as the distance from a surface of the sample 208 facing the electron-optical device and a surface of the electron-optical device facing the sample 208.

**FIG. 16** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 16**, the beam apertures 406 are in a hexagonal close packed array. The beam apertures 406 can also be differently arranged, e.g. in a rectangular array. The beam arrangement of the hexagonal arrangement in **FIG. 16** may be more densely packed than a square beam arrangement. The detector elements 405 may be arranged in a rectangular array or a hexagonal array (Note: the beam arrangement may be referred to as a multi-beam arrangement. These arrangements may be referred to as the grid of the multi-beam).

In an embodiment the beam apertures 406 have a pitch P of at least 20 µm, optionally at least 50 µm, optionally at least 100 µm, optionally at least 200 µm and optionally 210 µm. A greater pitch allows for the diameter d of the beam apertures 406 to be greater. In an embodiment the beam apertures 406 have a pitch P of at most 1000 µm, optionally at most 500 µm, and optionally at most 250 µm. The pitch of the beam apertures 406 defines the pitch of the sub-beams of the multi-beam of sub-beams (or multi-beam of electrons) that is projected toward the sample 208. In an embodiment the sub-beams of the multi-beam of electrons have a pitch of at least 50 µm, optionally at least 100 µm, optionally at least 200 µm and optionally 210 µm. In an embodiment the beam apertures 406 have a diameter d that is less than the pitch P. In an embodiment the beam apertures 406 have a diameter d that is at least 10 µm, and optionally at least 20 µm. In an embodiment the beam apertures 406 have a diameter d that is at most 100 µm, optionally at most 50 µm, and optionally at most 30 µm. A smaller diameter d improves the resolution such that smaller defects can be detected.

**FIG. 17** depicts at a larger scale a part of the detector 240 in cross section. The detector elements 405 form the bottommost surface of the detector 240, i.e. closest to the sample 208. Between the detector elements 405 and the main body of the substrate 404 circuitry layers such as a logic layer 407 may be provided. At least part of the signal processing system may be incorporated into the logic layer 407.

A wiring layer 408 or circuitry is provided on the backside of, or within, the substrate 404 and connected to the logic layer 407 by through-substrate vias 409. The number of through-substrate vias 409 (or vias) need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as signal electron, e.g. secondary electron, capture can be optimized for a range of landing energies.

The detector 240 may be implemented by integrating a CMOS chip detector into a bottom electrode of the objective lens array 241. Integration of a detector 240 into the objective lens array 241 or other component of the electron-optical device allows for the detection of electrons emitted in relation to multiple respective sub-beams. The CMOS chip is preferably orientated to face the sample (because of the small distance (e.g. 50 µm or less) between the sample and a bottom of the electron-optical device). In an embodiment, detector elements 405 to capture the signal electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens array 241); preferably with electrically isolating material separating the detector elements. Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The electron current collected by detector element 405 is amplified, for example by an amplifier such as a TIA.

The detector may be provided with multiple portions and more specifically, multiple detecting portions . The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG. 18**, which provides an example of such a detector.

As shown in **FIG. 18**, the detector element 405, in which an aperture 406 is defined and configured for the through passage of an electron beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. So each portion is a concentric ring.

In an embodiment, the objective lens array 241 is an exchangeable module, either on its own or in combination with other elements such as the control lens array 250 and/or the detector 240 and/or the beam shaping aperture array 262 and/or the sub-beam forming array 252. In an arrangement the whole electron-optical device may be exchangeable. The exchangeable module may be field replaceable, i.e. the module can be swapped for a new module by a field engineer. In an embodiment, multiple exchangeable modules are contained within the tool and can be swapped between operable and non-operable positions without opening the electron apparatus 40.

In an embodiment the exchangeable module comprises an electron-optical component, and specifically may be the electron-optical device, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the electron-optical device, it supports. In an arrangement the stage is removable. In an alternative design the exchangeable module comprising the stage is removable. The part of the electron apparatus 40 for the exchangeable module is isolatable, that is the part of the electron apparatus 40 is defined by a valve up-beam and a valve down-beam of the exchangeable module. The valves can be operated to isolate the environment between the valves from the vacuum up-beam and down-beam of the valves respectively enabling the exchangeable module to be removed from the electron apparatus 40 whilst maintaining the vacuum up-beam and down-beam of the part of the electron apparatus 40 associated with the exchangeable module. In an embodiment the exchangeable module comprises a stage. The stage is configured to support a device, such as the electron-optical device, relative to the beam path. In an embodiment the module comprises one or more actuators. The actuators are associated with the stage. The actuators are configured to move the device relative to the beam path. Such actuation may be used to align the device and the beam path with respect to each other.

Reference to a component or system of components or elements being controllable to manipulate an electron beam in a certain manner includes configuring a controller or control system or control unit to control the component to manipulate the electron beam in the manner described, as well optionally using other controllers or devices (e.g. voltage supplies and or current supplies) to control the component to manipulate the electron beam in this manner. For example, a voltage supply may be electrically connected to one or more components to apply potentials to the components, such as in a non-limited list the control lens array 250, the objective lens array 241, the condenser lenses 231, correctors, a collimator element array and deflector arrays 235, 265, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a sub-beam forming array to a last electron-optical element in a sub-beam path before a sample, may be electrostatic and/or may be in the form of an aperture array or a plate array.

In some arrangements one or more of the electron-optical elements are manufactured as a microelectromechanical system (MEMS) (i.e. using MEMS manufacturing techniques). MEMS are miniaturized mechanical and electromechanical elements that are made using microfabrication techniques. For example, in an embodiment, the exchangeable module is a MEMS module.

In an embodiment, the exchangeable module is configured to be replaceable within the electron-optical apparatus 40. In an embodiment, the exchangeable module is configured to be field replaceable. Field replaceable is intended to mean that the module may be removed and replaced with the same or different module while maintaining the vacuum in which the electron-optical apparatus 40is located. Only a section of the electron-optical apparatus 40is vented corresponding to the module is vented for the module to be removed and returned or replaced. The control lens array 250 may be in the same module as an objective lens array 241, i.e. forming an objective lens array assembly or objective lens arrangement, or it may be in a separate module.

References to upper and lower, up and down, above and below should be understood as referring to directions parallel to the (typically but not always vertical) up-beam and down-beam directions of the beam or multi-beam of electrons impinging on the sample 208. Thus, references to up beam and down beam are intended to refer to directions in respect of the beam path independently of any present gravitational field.

An electron apparatus according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

There is provided the following clauses:
Clause 1. A charged particle-optical device for projecting a plurality of charged particle beams along respective beam paths towards a sample location, the device comprising: a charged particle-optical lens assembly configured to manipulate the beams, the lens assembly comprising a plurality of plates each having an array of apertures for passage of beam paths, the plates located at different plate locations along the beam paths; and a controller configured to control the charged particle-optical device such that in use charged particles of the beams can have different energy values at the different plate locations along the beam paths; wherein the lens assembly comprises a corrector comprising a plurality of individual correctors configured to perform aberration correction at respective apertures independently of each other, wherein the corrector is associated with the plate located at the plate location at which the energy value is smallest and/or strength of an electric field adjacent to the plate is greatest and/or a ratio of the energy value to strength of an electric field adjacent to the plate is smallest.
Clause 2. The charged particle-optical device of clause 1, wherein the corrector is associated with the associated plate by comprising a corrector plate located adjacent to the associated plate.
Clause 3. The charged particle-optical device of clause 2, wherein the corrector plate is located such that its nearest plate of the lens assembly is the associated plate.
Clause 4. The charged particle-optical device of clause 1, wherein the corrector is associated with the associated plate by being integrated into the associated plate.
Clause 5. The charged particle-optical device of clause 4, wherein the associated plate performs a lensing function at the apertures and the individual correctors are configured to provide all of the lensing function.
Clause 6. The charged particle-optical device of any preceding clause, wherein the controller is configured to control electric potentials of the plates such that in use beam width perpendicular to the beam paths varies among the plate locations, and the associated plate is located at the plate location at which the beam width is smallest.
Clause 7. The charged particle-optical device of any preceding clause, wherein the lens assembly is configured to decelerate charged particles towards the sample location and the associated plate is at a downbeam end of the lens assembly.
Clause 8. The charged particle-optical device of any of clauses 1-6, wherein the lens assembly is configured to accelerate charged particles towards the sample location and the associated plate is at is at an upbeam end of the lens assembly.
Clause 9. The charged particle-optical device of any of clauses 1-6, wherein the lens assembly is an Einzel lens assembly and the associated plate is an intermediate plate of the Einzel lens assembly.
Clause 10. The charged particle-optical device of any preceding clause, wherein the lens assembly is comprised in a stack.
Clause 11. The charged particle-optical device of clause 10, wherein the corrector is mechanically integrated in the stack.
Clause 12. The charged particle-optical device of any preceding clause, wherein the corrector is located in a region defined between components at substantially the same electric potential.
Clause 13. The charged particle-optical device of any preceding clause, comprising a shield plate facing the corrector.
Clause 14. The charged particle-optical device of clause 13, wherein the shield plate comprises portions extending perpendicular to the beam path corresponding to respective apertures of the corrector and that, desirably are rotationally symmetric about an axis of the beam path passing through the respective apertures of the corrector.
Clause 15. The charged particle-optical device of clause 13 or 14, wherein the shield plate is configured to reduce crosstalk between the individual correctors.
Clause 16. The charged particle-optical device of any of clauses 13-15, wherein the shield plate is formed by one of the plates of the lens assembly.
Clause 17. The charged particle-optical device of any of clauses 13-16, wherein the shield plate is a beam limiting aperture array for example a beam shaper array.
Clause 18. The charged particle-optical device of any of clauses 13-16, comprising a detector array for detecting signal charged particles from the sample location, wherein the shield plate is formed by a detector array.
Clause 19. The charged particle-optical device of clause 18, configured such that in use the detector array is at a potential difference of at most 200V from a reference potential of the charged particle-optical device, wherein the reference potential is desirably ground potential.
Clause 20. The charged particle-optical device of any of clauses 13-19, wherein a surface of the shield plate is in a region substantially free of electric field, for example the shield plate is a lens plate and desirably the surface of the shield plate that is in the region substantially free of electric field faces away from another plate of the lens assembly, an electric field being between the shield plate and the other plate.
Clause 21. The charged particle-optical device of any preceding clause, wherein each individual corrector comprises a plurality of electrodes for a respective beam path.
Clause 22. The charged particle-optical device of clause 21, wherein the corrector is configured to apply an electric potential of at most 50V, optionally at most 20V, optionally at most 10V, optionally at most 5V, and optionally at most 2V, to the electrodes.
Clause 23. The charged particle-optical device of any preceding clause, wherein each individual corrector comprises a stigmator for the respective beam path and/or is configured to adjust a cross-sectional shape of the respective beam.
Clause 24. The charged particle-optical device of any preceding clause, wherein the corrector comprises a CMOS device.
Clause 25. The charged particle-optical device of any preceding clause, wherein the controller is configured to control the corrector through a serial bus.
Clause 26. The charged particle-optical device of any preceding clause, wherein the corrector comprises a digital to analogue converter configured to convert control signals from the controller into electrode signals to electrodes of the corrector.
Clause 27. The charged particle-optical device of clause 26, wherein the digital to analogue converter is comprised in a plate comprising the corrector.
Clause 28. The charged particle-optical device of clause 27, wherein the plate comprising the corrector comprises a plurality of portions to which are assigned respective individual correctors and in which are defined respective apertures and respective digital to analogue converters.
Clause 29. The charged particle-optical device of any preceding clause, wherein the controller is configured to control the charged particle-optical device at least partly by controlling electric potentials of a plurality of the plates such that in use charged particles of the beams have different energy values at the different plate locations.
Clause 30. The charged particle-optical device of any preceding clause, wherein the lens assembly is an objective lens assembly configured to project the beams to the sample location.
Clause 31. The charged particle-optical device of any of clauses 1-29, wherein the lens assembly is a condenser lens assembly configured to manipulate the beams upbeam of an objective lens assembly.
Clause 32. A charged particle-optical device for projecting a plurality of charged particle beams along respective beam paths towards a sample location, the device comprising: a charged particle-optical lens assembly configured to manipulate the beams, the lens assembly comprising a plurality of plates each having an array of apertures for passage of beam paths and an array of lenses configured to control lensing at respective apertures; wherein at least one of the plurality of plates is a corrector plate, wherein in the corrector plate the lensing comprises aberration correction.
Clause 33. The charged particle-optical device of clause 32, wherein the corrector plate is a lens plate configured to perform a lensing function at the apertures.
Clause 34. The charged particle-optical device of clause 32 or 33, wherein the lenses are connected to a common controllable electrical potential.
Clause 35. The charged particle-optical device of any of clauses 32-34, wherein the corrector plate comprises a plurality of individual correctors configured to perform aberration correction at respective apertures independently of each other.
Clause 36. The charged particle-optical device of any of clauses 32-35, further comprising a controller configured to control the lenses.
Clause 37. The charged particle-optical device of any of clauses 32-36, wherein the individual correctors are integrated in the plate.
Clause 38. A charged particle-optical apparatus comprising: the charged particle-optical device of any preceding clause; and a support for a sample toward which the charged particle beams are directed.
Clause 39. A method for controlling a charged particle-optical device so as to project a plurality of charged particle beams along respective beam paths towards a sample location, the method comprising: manipulating the beams with a charged particle-optical lens assembly comprising a plurality of plates each having a plurality of apertures for passage of the beam paths, the plates located at different plate locations along the beam paths; controlling the charged particle-optical device such that charged particles of the beams have different energy values at the different plate locations along the beam paths; and performing aberration correction at respective apertures independently of each other with a plurality of individual correctors of a corrector, wherein the corrector is associated with the plate located at the plate location at which the energy value is smallest and/or strength of an electric field adjacent to the plate is greatest and/or a ratio of the energy value to strength of an electric field adjacent to the plate is smallest.
Clause 40. A method for controlling a charged particle-optical device so as to project a plurality of charged particle beams along respective beam paths towards a sample location, the method comprising: controlling lensing of the beams at respective apertures of a corrector plate of a charged particle-optical lens assembly with an array of lenses of the corrector plate; wherein the lensing comprises aberration correction.
Clause 41. A charged particle-optical device for projecting a plurality of charged particle beams along respective beam paths towards a sample location, the device comprising: a charged particle-optical lens assembly configured to manipulate the beams, the lens assembly comprising a plurality of plates each having an array of apertures for passage of beam paths, the plates located at different plate locations along the beam paths; and a controller configured to control the charged particle-optical device such that in use the plates at the different plate locations along the beam paths are controllable to have different applied potentials; wherein the lens assembly comprises a corrector comprising a plurality of individual correctors configured to perform aberration correction at respective apertures independently of each other, the plurality of plates comprising an associated plate, wherein the corrector is associated with the associated plate and the associated plate is: the most down beam plate of the assembly; or the most up beam plate of two plates of the assembly having the greatest applied potential difference.
Clause 42. The charged particle-optical device of clause 41, wherein the corrector is located at the plate location at which the energy value is smallest and/or strength of an electric field adjacent to the plate is greatest and/or a ratio of the energy value to strength of an electric field adjacent to the plate is smallest.

## Claims

1. A charged particle-optical device for projecting a plurality of charged particle beams along respective beam paths towards a sample location, the device comprising:
a charged particle-optical lens assembly configured to manipulate the beams, the lens assembly comprising a plurality of plates each having an array of apertures for passage of beam paths, the plates located at different plate locations along the beam paths; and
a controller configured to control the charged particle-optical device such that in use charged particles of the beams can have different energy values at the different plate locations along the beam paths;
wherein the lens assembly comprises a corrector comprising a plurality of individual correctors configured to perform aberration correction at respective apertures independently of each other,
wherein the corrector is associated with the plate located at the plate location at which the energy value is smallest and/or strength of an electric field adjacent to the plate is greatest and/or a ratio of the energy value to strength of an electric field adjacent to the plate is smallest.

2. The charged particle-optical device of claim 1, wherein the corrector is associated with the associated plate by comprising a corrector plate located adjacent to the associated plate or by being integrated into the associated plate.

3. The charged particle-optical device of claim 2, wherein the associated plate performs a lensing function at the apertures and the individual correctors are configured to provide all of the lensing function.

4. The charged particle-optical device of any preceding claim, wherein the controller is configured to control electric potentials of the plates such that in use beam width perpendicular to the beam paths varies among the plate locations, and the associated plate is located at the plate location at which the beam width is smallest.

5. The charged particle-optical device of any preceding claim, wherein the lens assembly is:
configured to decelerate charged particles towards the sample location and the associated plate is at a downbeam end of the lens assembly configured to accelerate charged particles towards the sample location and the associated plate is at is at an upbeam end of the lens assembly; or an Einzel lens assembly and the associated plate is an intermediate plate of the Einzel lens assembly.

6. The charged particle-optical device of any preceding claim, wherein the lens assembly is comprised in a stack, desirably the corrector is mechanically integrated in the stack.

7. The charged particle-optical device of any preceding claim, wherein the corrector is located in a region defined between components at substantially the same electric potential.

8. The charged particle-optical device of any preceding claim, comprising a shield plate facing the corrector.

9. The charged particle-optical device of claim 8, wherein the shield plate comprises portions extending perpendicular to the beam path corresponding to respective apertures of the corrector and that, desirably are rotationally symmetric about an axis of the beam path passing through the respective apertures of the corrector.

10. The charged particle-optical device of claim 8 or 9, wherein the shield plate is configured to reduce crosstalk between the individual correctors.

11. The charged particle-optical device of any of claims 8-10, wherein the shield plate is formed by one of the plates of the lens assembly.

12. The charged particle-optical device of any of claims 8-11, wherein the shield plate is a beam limiting aperture array for example a beam shaper array; or wherein the shield plate is formed by a detector array, the charged particle-optical device comprising the detector array for detecting signal charged particles from the sample location,

13. The charged particle-optical device of any of claims 8-12, wherein a surface of the shield plate is in a region substantially free of electric field,.

14. The charged particle-optical device of any preceding claim, wherein each individual corrector comprises a plurality of electrodes for a respective beam path.

15. The charged particle-optical device of any preceding claim, wherein each individual corrector comprises a stigmator for the respective beam path and/or is configured to adjust a cross-sectional shape of the respective beam.
